# EUROPEAN PATENT APPLICATION

(11) **EP 4 815 693 A1**
(43) Date of publication of application: **30.09.2026**
(21) Application number: 24894757.4
(22) Date of filing: 18.11.2024
(51) Int. Cl.: H10K 59/121, H10K 59/35, H10K 59/80

(54) **ORGANIC LIGHT-EMITTING DISPLAY DEVICE**

(30) Priority: 20.11.2023 KR 20230160690; 15.11.2024 KR 20240163431
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/096615
(87) International publication number: WO 2025/110867

(57) **Abstract**

The organic light-emitting display device may include a plurality of three-dimensional structures on a substrate, and a plurality of pixels on the substrate. The plurality of pixels may each include a first subpixel, a second subpixel, and a third subpixel having a three-dimensional structure. The first subpixel may be disposed on a first lateral surface of the three-dimensional structure, and the second subpixel may be disposed on a second lateral surface of the three-dimensional structure. The second subpixel may be disposed to horizontally overlap the first subpixel, and the third subpixel may be disposed on the first subpixel and the second subpixel. The first subpixel may include a first organic light-emitting element, the second subpixel may include a second organic light-emitting element, and the third subpixel may include a third organic light-emitting element.

## Description

### [Technical Field]

The embodiment relates to an organic light-emitting display device.

### [Background Art]

Recently, as society has entered the full-fledged information age, interest in information displays that process and display large amounts of information has been increasing. In addition, the display field is developing rapidly due to the increasing demand for portable information media. In response to these, various lightweight and thin flat panel display devices have been in the spotlight.

Among these flat panel display devices, an organic light-emitting display device (hereinafter referred to as OLED) has been in the spotlight. The OLED is being actively developed for use as a display device for a head-mounted display (HMD) that is mounted close to the human eye. The HMD is worn in the form of a helmet or glasses, and virtual reality (VR) or augmented reality (AR) can be implemented.

The HMD is equipped with a high-resolution and small OLED. The high-resolution and small OLED is disposed with organic light-emitting elements on a driving circuit formed using a wafer-based semiconductor process. Meanwhile, glasses-type HMD requires brighter and clearer screen in a very small screen size. To this end, the amount of light from the organic light-emitting element and the light extraction efficiency thereof must be maximized. In addition, light leakage, etc., between pixels must be suppressed to improve image quality. The technology to improve light extraction efficiency applicable to ultra-high resolution is expected to be widely applied to a large-screen display industry such as a mobile device and an IT device.

Meanwhile, a fine metal mask (FMM) is used as a deposition pattern mask to deposit an organic emission layer constituting an organic light-emitting element by subpixel.

However, it is quite difficult to form an organic emission layer by subpixel using an FMM when manufacturing a high-definition (e.g., 500 PPI or higher) display device or a large-area (e.g., 8^{th} generation or higher) display device. In addition, there is a limit to further increasing the high-definition when using an FMM. In addition, there are problems in that the yield is reduced and the manufacturing cost increases when using an FMM. In addition, when using FMM, there is a problem with decreased product lifespan because the optimization of deposition is difficult.

Meanwhile, as the resolution of the display has recently increased, the pixel resolution (ppi) has also increased, and the gap between pixels (or subpixels) has become narrower. In addition, as an efficiency of the light-emitting material for the organic light-emitting element has increased, it has the advantage of being able to produce high luminance with low current and voltage, which reduces power consumption.

However, there is still a problem of low lifetime luminous efficacy in displays with high resolution. Here, the lifetime luminous efficacy can be defined as the lifetime ratio or brightness to the emission area ratio. For example, in terms of the product, when the emission area ratio increases, brightness may increase for the same lifetime, or lifetime may increase for the same brightness, or both lifetime and brightness may increase.

### [Disclosure]

### [Technical Problem]

The embodiments aim to solve the above-mentioned problems and other problems.

Another object of the embodiments is to provide a high-definition and high-resolution organic light-emitting display device.

Another object of the embodiments is to provide an organic light-emitting display device that does not use FMM.

Another object of the embodiment is to provide an organic light-emitting display device capable of improving image quality.

The technical problems of the embodiment are not limited to those described in this section, and comprise those that may be understood through the description of the invention.

### [Technical Solution]

In order to achieve the above or other objects, according to one aspect of the embodiment, an organic light-emitting display device, comprising: a plurality of three-dimensional structures on a substrate; and a plurality of pixels on the substrate, wherein the plurality of pixels each comprise a first subpixel, a second subpixel, and a third subpixel having a three-dimensional structure, wherein the first subpixel is disposed on a first lateral surface of the three-dimensional structure, and the second subpixel is disposed on a second lateral surface of the three-dimensional structure, wherein the second subpixel is disposed to horizontally overlap the first subpixel, and the third subpixel is disposed on the first subpixel and the second subpixel, and wherein the first subpixel comprises a first organic light-emitting element, the second subpixel comprises a second organic light-emitting element, and the third subpixel comprises a third organic light-emitting element.

The third subpixel may be disposed on an upper surface of the three-dimensional structure.

The second organic light-emitting element may be disposed to overlap horizontally with the first organic light-emitting element, and the third organic light-emitting element is disposed on the upper surface of the three-dimensional structure.

The first organic light-emitting element, the second organic light-emitting element, and the third organic light-emitting element may each comprise an anode electrode, a low-resistance layer, an organic emission layer, and a cathode electrode.

The anode electrode may be independently disposed in the first subpixel, the second subpixel, and the third subpixel.

A low-resistance layer of the first organic light-emitting element and a low-resistance layer of the second organic light-emitting element may be disposed to be spaced apart from each other between the plurality of three-dimensional structures, and a first organic emission layer of the first organic light-emitting element and a second organic emission layer of the second organic light-emitting element may be disposed to overlap horizontally between the plurality of three-dimensional structures.

A low-resistance layer, an organic emission layer, and a cathode electrode of the first organic light-emitting element and a low-resistance layer, an organic emission layer, and a cathode electrode of the second organic light-emitting element may be spaced apart from each other on the upper surface of the three-dimensional structure.

A first anode electrode of the first organic light-emitting element and a second anode electrode of the second organic light-emitting element may each comprise a reflective metal, and a first cathode electrode of the first organic light-emitting element and a second cathode electrode of the second organic light-emitting element may each comprise a transparent or translucent conductive film.

The third subpixel may be disposed on the first subpixel and the second subpixel between the plurality of three-dimensional structures.

A size of the pixel may be a same as a size of the third subpixel.

A size of the pixel may be equal to a sum of a size of the first subpixel and a size of the second subpixel.

The second organic light-emitting element may be disposed to horizontally overlap the first organic light-emitting element, and the third organic light-emitting element may be disposed to vertically overlap the first organic light-emitting element and the second organic light-emitting element.

The first organic light-emitting element, the second organic light-emitting element, and the third organic light-emitting element may each comprise an anode electrode, an organic emission layer, and a cathode electrode, the anode electrode may be independently disposed in the first subpixel, the second subpixel, and the third subpixel, and the cathode electrode may be commonly disposed in the first subpixel and the second subpixel.

The first subpixel, the second subpixel, and the third subpixel may each comprise an emission region and a non-emission region, and the emission region may have a size corresponding to the anode electrode.

A size of a third anode electrode of the third organic light-emitting element may be greater than a size of a first anode electrode of the first organic light-emitting element or a size of a second anode electrode of the second organic light-emitting element.

A third anode electrode of the third organic light-emitting element may vertically overlap a first anode electrode of the first organic light-emitting element and a second anode electrode of the second organic light-emitting element.

An end of an organic emission layer of the first organic light-emitting element and an end of an organic emission layer of the second organic light-emitting element may be positioned lower than an upper surface of the three-dimensional structure.

The organic light-emitting display device may comprise a plurality of first banks between the plurality of three-dimensional structures; and a plurality of second banks between the plurality of third subpixels.

A distance between the plurality of second banks may be a same as a width of the pixel or a width of the third subpixel.

The organic light-emitting display device may comprise a plurality of insulating layers between the first organic light-emitting element, the second organic light-emitting element, and the third organic light-emitting element. The plurality of insulating layers may comprise at least one organic insulating layer and at least one inorganic insulating layer.

The first lateral surface and the second lateral surface of the three-dimensional structure may be each inclined or perpendicular to a ground.

### [Advantageous Effects]

The effects of the organic light-emitting display device according to the embodiment are described as follows.

According to at least one of the embodiments, there is an advantage that a first subpixel, a second subpixel, and a third subpixel may be disposed three-dimensionally to form a pixel, so that a size of a pixel become smaller and smaller, thereby enabling a high-definition and ultra-high-resolution display to be implemented.

According to at least one of the embodiments, the first subpixel, the second subpixel, and the third subpixel that form the pixel may be disposed three-dimensionally, so that a size of a blue subpixel increases to a size of the pixel, thereby greatly increasing the emission region and improving the lifetime luminous efficacy.

According to at least one of the embodiments, since the organic light-emitting material constituting a third organic light-emitting layer is deposited on the entire region of the substrate, there is an advantage in that the process freedom can be increased and the yield can be improved because there is no need to use a separate mask.

According to at least one of the embodiments, since the first subpixel and the second subpixel are disposed on a first lateral surface and a second lateral surface of a three-dimensional structure, there is an advantage in that high definition and high resolution can be implemented without reducing the emission area of each of the first subpixel and the second subpixel. In addition, since the first subpixel and the second subpixel are disposed on the first lateral surface and the second lateral surface of the three-dimensional structure using the three-dimensional structure, a high definition (e.g., 500 PPI or higher) display or a large-area (e.g., 8^{th} generation or higher) display can be implemented because an FMM is not required. Since a separate deposition pattern mask such as an FMM is not used, the manufacturing cost can be significantly reduced.

According to at least one of the embodiments, there is an advantage in that a low-resistance layer of a first organic light-emitting element and a low-resistance layer of a second organic light-emitting element may be cut off on a first bank between the three-dimensional structures or on an upper surface of the three-dimensional structure, so that the transverse current leakage between the first subpixel and the second subpixel can be prevented. The low-resistance layer may comprise, for example, a hole injection layer, a charge generation layer, etc.

Additional scope of applicability of the embodiments will become apparent from the detailed description below. However, since various changes and modifications within the spirit and scope of the embodiments may be clearly understood by those skilled in the art, it should be understood that the detailed description and specific embodiments, such as the preferred embodiments, are given by way of example only.

### [Description of Drawings]

FIG. 1 is a plan view illustrating an organic light-emitting display device according to a first embodiment.
FIG. 2 is a cross-sectional view illustrating an organic light-emitting display device according to the first embodiment.
FIG. 3 illustrates a stacked structure for each organic light-emitting element.
FIG. 4 schematically illustrates a design structure of a three-dimensional structure and a design structure of a second evaporation source device.
FIGS. 5A and 5B illustrate a first organic light-emitting element and a second organic light-emitting element disposed on a first bank between three-dimensional structures according to the comparative example and the embodiment.
FIGS. 6A and 6B illustrate a first organic light-emitting element and a second organic light-emitting element disposed on an upper surface of a three-dimensional structure according to the comparative example and the embodiment.
FIG. 7 is a cross-sectional view illustrating an organic light-emitting display device according to a second embodiment.
FIG. 8 is a plan view illustrating an organic light-emitting display device according to a second embodiment.
FIG. 9 is a cross-sectional view illustrating an organic light-emitting display device according to a third embodiment.
FIGS. 10A to 10C illustrate a manufacturing process according to a first embodiment for preventing a transverse current leakage.
FIGS. 11A to 11C illustrate a manufacturing process according to a second embodiment for preventing a transverse current leakage.
FIG. 12 illustrates an additional bank disposed on an upper surface of a three-dimensional structure.
FIGS. 13A to 13D illustrate a manufacturing process of an additional bank disposed on an upper surface of a three-dimensional structure.
FIG. 14 is a cross-sectional view illustrating an organic light-emitting display device according to a fourth embodiment.
FIG. 15 illustrates a light propagation path in the L region of FIG. 14.

The sizes, shapes, and numbers of the components illustrated in the drawings may differ from the actual ones. In addition, even if the same components are illustrated with different sizes, shapes, and numbers between the drawings, this is only an example in the drawings, and the same components may have the same sizes, shapes, and numbers between the drawings.

### [Mode for Invention]

Hereinafter, the embodiments disclosed in this specification will be described in detail with reference to the attached drawings. Regardless of the drawing symbols, identical or similar components will be assigned the same reference numbers and redundant descriptions thereof will be omitted. The suffixes 'module' and 'part' used for components in the following description are assigned or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this comprises that it may be directly on the other element or that other intermediate elements may exist between them.

The following description is limited to a top-emission type display, but the embodiment may also be applied to a bottom-emission type display. A top-emission type organic light-emitting display device may display an image by emitting light in an upward direction, i.e., toward the front side. A bottom-emission type organic light-emitting display device may display an image by emitting light in a downward direction, i.e., toward the rear side.

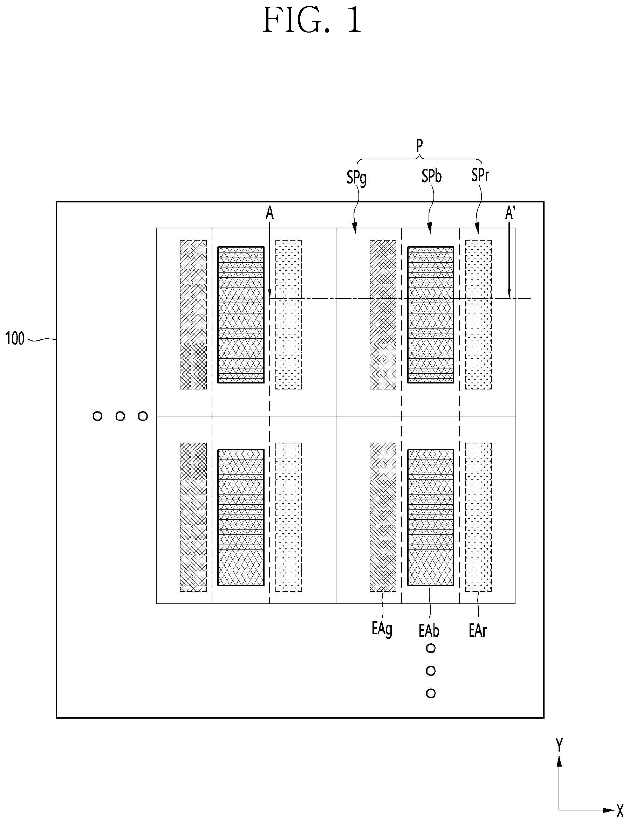

FIG. 1 is a plan view illustrating an organic light-emitting display device according to a first embodiment.

As illustrated in FIG. 1, the organic light-emitting display device according to an embodiment may comprise a plurality of pixels P arranged on a substrate 100.

The substrate 100 may comprise a display region and a non-display region surrounding the display region. A plurality of pixels P may be disposed on the display region. A driving device such as a gate driver, a data driver, etc. may be disposed in the non-display region, but is not limited thereto. The plurality of pixels P may be arranged along a first direction X. The plurality of pixels P may be arranged along a second direction Y. The plurality of pixels P may be arranged in a matrix. The first direction X may be a horizontal direction or a lateral direction, and the second direction Y may be a vertical direction or a longitudinal direction.

Each pixel P may comprise a plurality of subpixels SPr, SPg, and SPb. Each pixel P may comprise subpixels SPr, SPg, and SPb of at least three different colors. Although not illustrated, the pixel P may further comprise a colorless transparent region to implement a transparent display.

Each pixel P may comprise a first subpixel SPr, a second subpixel SPg, and a third subpixel SPb. In this instance, the first subpixel SPr may be a red subpixel, the second subpixel SPg may be a green subpixel, and the third subpixel SPb may be a blue subpixel.

In FIG. 1, a pixel P may be defined in which the second subpixel SPg, the third subpixel SPb, and the first subpixel SPr may be disposed in the order of the first direction X. However, they may be disposed in the order of the first subpixel SPr, the second subpixel SPg and the third subpixel SPb, or in the order of the third subpixel SPb, the first subpixel SPr and the second subpixel SPg, along the first direction X.

At this time, the first subpixel SPr, the second subpixel SPg, and the third subpixel SPb may not vertically overlap each other.

As a first example, the plurality of subpixels SPr, SPg, and SPb may be separated into one or more pixel P units or row-line units along the second direction Y. For example, the first subpixel SPr may be separated into one or more pixel P units or row-line units along the second direction Y, the second subpixel SPg may be separated into one or more pixel P units or row-line units along the second direction Y, and the third subpixel SPb may be separated into one or more pixel P units or row-line units along the second direction Y.

As a second example, the plurality of subpixels SPr, SPg, and SPb may be arranged in a stripe shape along the second direction Y. In the stripe shape structure, each of the plurality of subpixels SPr, SPg, and SPb may be arranged continuously without being separated along the second direction Y. For example, the second subpixel SPg may be arranged continuously along the second direction Y, the first subpixel SPr may be arranged continuously along the second direction Y, and the third subpixel SPb may arranged continuously along the second direction Y.

Meanwhile, in the first and second examples, the second subpixel SPg, the first subpixel SPr, and the third subpixel SPb may be arranged alternately in a column-line unit along the first direction X. That is, in the embodiment, the second subpixel SPg, the first subpixel SPr, and the third subpixel SPb having different colors may be disposed in a side-by-side structure along the first direction X. In the side-by-side structure, it is very important to implement high definition and high resolution without reducing the emission area of each of the plurality of subpixels SPr, SPg, and SPb.

Meanwhile, as illustrated in FIG. 1, in the embodiment, the plurality of pixels P may comprise the first subpixel SPr, the second subpixel SPg, and the third subpixel SPb having a three-dimensional structure. That is, the first subpixel SPr, the second subpixel SPg, and the third subpixel SPb may be disposed three-dimensionally, thereby configuring the pixel P. That is, the first subpixel SPr, the second subpixel SPg, and the third subpixel SPb may be disposed not only horizontally but also vertically relative to each other, thereby configuring the pixel P.

For example, the second subpixel SPg may be disposed to overlap horizontally with the first subpixel SPr, and the third subpixel SPb may be disposed to overlap vertically with the first subpixel SPr and the second subpixel SPg.

As will be described later, the first subpixel SPr and the second subpixel SPg may be disposed on the first lateral surface SS1 and the second lateral surface SS2 of the three-dimensional structure 130. Accordingly, high definition and high resolution can be implemented without reducing the emission area of each of the first subpixel SPr and the second subpixel SPg. In addition, since the first subpixel SPr and the second subpixel SPg are disposed on the first lateral surface SS1 and the second lateral surface SS2 of the three-dimensional structure 130 without using an FMM, a high definition (e.g., 500 PPI or higher) display or a large-area (e.g., 8^{th} generation or higher) display can be implemented. Since a separate deposition pattern mask such as FMM is not used, the manufacturing cost can be significantly reduced.

Meanwhile, the first subpixel SPr may emit first color light, the second subpixel SPg may emit second color light, and the third subpixel SPb may emit third color light. Accordingly, a full-color image may be displayed for each unit pixel P by the first color light, the second color light, and the third color light. For example, the first color light may be red color light, the second color light may be green color light, and the third color light may be blue light, but is not limited thereto.

According to an embodiment, the first subpixel SPr, the second subpixel SPg, and the third subpixel SPb may be disposed three-dimensionally to form the pixel P, so that the size of the pixel P can be further reduced, and a high-definition and ultra-high-resolution display can be implemented.

Meanwhile, as illustrated in FIG. 1, the first subpixel SPr, the second subpixel SPg, and the third subpixel SPb may each comprise an emission region EAr, EAg, and EAb, and a non-emission region. The emission region EAr, EAg, and EAb may be a region from which corresponding color light is emitted, and the wider the emission region EAr, EAg, and EAb are, the higher the lifetime luminous efficiency may be. The non-emission region may be a remaining region excluding the emission region EAr, EAg, and EAb in the first subpixel SPr, the second subpixel SPg, and the third subpixel SPb, respectively.

The first emission region EAr of the first subpixel SPr, the second emission region EAg of the second subpixel SPg, and the third emission region EAb of the third subpixel SPb may not vertically overlap each other.

### [First Embodiment]

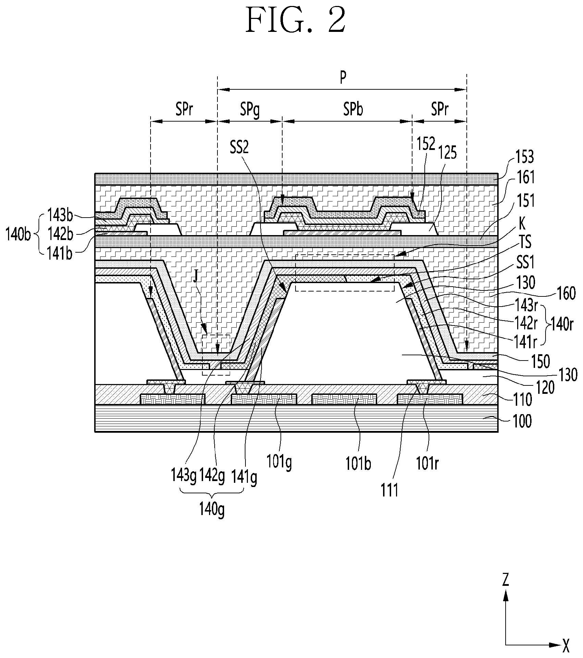

FIG. 2 is a cross-sectional view illustrating an organic light-emitting display device according to the first embodiment. FIG. 2 is a cross-sectional view taken along line A-A' of the organic light-emitting display device of FIG. 1.

Referring to FIGS. 1 and 2, the organic light-emitting display device according to the first embodiment may comprise a substrate 100, a plurality of driving circuits 101r, 101g, and 101b, a protective layer 110, a plurality of three-dimensional structures 130, a plurality of banks 120 and 125, a plurality of organic light-emitting elements 140r, 140g, and 140b, a plurality of insulating layers 150 to 153, 160, and 161, etc.

A plurality of pixels P may be disposed on the substrate 100. The plurality of pixels P may each comprise a first subpixel SPr, a second subpixel SPg, and a third subpixel SPb having a three-dimensional structure.

As described above, in order to implement a high-definition and ultra-high-resolution display, the first subpixel SPr, the second subpixel SPg, and the third subpixel SPb may be disposed three-dimensionally. The third subpixel SPb may be disposed on the first subpixel SPr and may vertically overlap with the first subpixel SPr. The third subpixel SPb may be disposed on the second subpixel SPg and may vertically overlap with the second subpixel SPg.

A plurality of driving circuits 101r, 101g, and 101b may be disposed on the substrate 100, and the protective layer 110 may be disposed on the plurality of driving circuits 101r, 101g, and 101b.

The substrate 100 may be a substrate having characteristics such as rigid, flexible, foldable, and rollable. The substrate 100 may be made of a silicon wafer, glass, plastic, ceramic, etc. The substrate 100 may be made of a transparent material or an opaque material.

The plurality of driving circuits may comprise a first driving circuit 101r, a second driving circuit 101g, and a third driving circuit 101b. The first driving circuit 101r may be connected to the first subpixel SPr and may drive the first subpixel SPr to emit a first color light. The second driving circuit 101g may be connected to the second subpixel SPg and may drive the second subpixel SPg to emit a second color light. The third driving circuit 101b may be connected to the third subpixel SPb and may drive the third subpixel SPb to emit a third color light.

Each driving circuit may comprise a plurality of transistors and at least one capacitor. One of the plurality of transistors may be a driving transistor.

The protective layer 110 may be disposed on the plurality of driving circuits 101r, 101g, and 101b to protect the plurality of driving circuits 101r, 101g, and 101b. The protective layer 110 may be a planarization layer for stably forming layers thereon.

The protective layer 110 may be a single layer formed of an inorganic film or an organic film. The protective layer 110 may be multiple layers of inorganic films, or a combination of multiple layers of inorganic films and multiple layers of organic films. The protective layer 110 may be formed of a silicon oxide film (SiOx), a silicon nitride film (SiNx), or a multilayer thereof.

For example, the protective layer 110 may be composed of a multilayer structure of an organic film and an inorganic film. In this instance, the organic film may comprise an acrylic resin, an epoxy resin, a phenolic resin, a polyamide resin, a polyimide resin, etc. The inorganic film may comprise a silicon oxide film (SiOx), a silicon nitride film (SiNx), etc.

Meanwhile, a plurality of three-dimensional structures 130 may be disposed on the substrate 100. The plurality of three-dimensional structures 130 may be disposed on the protective layer 110. As will be described later, a plurality of first banks 120 may be disposed on the protective layer 110 between the plurality of three-dimensional structures 130. The plurality of first banks 120 may be omitted.

The three-dimensional structure 130 may have a first lateral surface SS1, a second lateral surface SS2, and a top surface TS. The upper surface TS will be omitted, so that an upper end of the first lateral surface SS1 and an upper end of the second lateral surface SS2 may meet each other.

The first subpixel SPr may be disposed on the first lateral surface SS1 of the three-dimensional structure 130, the second subpixel SPg may be disposed on the second lateral surface SS2 of the three-dimensional structure 130, and the third subpixel SPb may be disposed on the upper surface TS of the three-dimensional structure 130. The third subpixel SPb may not horizontally overlap with the first subpixel SPr or the second subpixel SPg, and the third subpixel SPb may be disposed on the first subpixel SPr and the second subpixel SPg.

With this structure, one pixel P comprising the first subpixel SPr, the second subpixel SPg, and the fourth subpixel may be configured by one three-dimensional structure 130. In this instance, the number of pixels P may be provided as many as the number of three-dimensional structures 130.

It is possible to implement high definition and high resolution without reducing the emission area of each subpixel SPg and SPr.

In the drawing, the lateral surface of the three-dimensional structure 130 has a straight surface, but may have a curved surface or an uneven surface. The lateral surface may be called a wall surface. The lateral surface and the wall surface may be used interchangeably.

The three-dimensional structure 130 may have a dot structure. The three-dimensional structure 130 may be disposed in a matrix along a first direction X and a second direction Y. The three-dimensional structure 130 may be separated into pixel P units or column-line units along the first direction X. The three-dimensional structure 130 may be separated into pixel P units or row-line units along the second direction Y. The three-dimensional structure 130 may be separated into two or more pixel P units or row-line units along the second direction Y. The three-dimensional structure 130 may be disposed continuously in a stripe shape along the second direction Y. That is, the three-dimensional structure 130 may be disposed long without being separated along the second direction Y.

The three-dimensional structure 130 may be separated into two or more pixel P units or row-line units along the second direction Y.

The first lateral surface SS1 and the second lateral surface SS2 of the three-dimensional structure 130 may each have an inclined surface inclined at a predetermined angle with respect to the ground.

The height or width of the three-dimensional structure 130 and the manufacturing method of the three-dimensional structure 130 may be determined according to the resolution of the organic light-emitting display device.

A plurality of three-dimensional structures 130 may be spaced apart with a separation region therebetween. A plurality of pixels P may be distinguished by a plurality of separation regions. That is, one pixel P may be defined between the adjacent separation regions.

The plurality of banks 120 and 125 may comprise a plurality of first banks 120, a plurality of second banks 125, etc.

The plurality of first banks 120 may be disposed on the protective layer 110 between the plurality of first subpixels SPr and the plurality of second subpixels SPg. The plurality of first banks 120 may be disposed in separation regions between the plurality of three-dimensional structures 130. The plurality of second banks 125 may be disposed on the second inorganic insulating layer 151 between the plurality of third subpixels SPb.

The first bank 120 may serve to distinguish the pixels P, and the second bank 125 may serve to distinguish the adjacent third subpixels SPb.

In the drawing, the thickness, size, shape, etc. of the first bank 120 and the second bank 125 are illustrated differently from each other, and the thickness, size, shape, etc. may be changed.

The first bank 120 and/or the second bank 125 may comprise an inorganic material or an organic material. For example, the first bank 120 and/or the second bank 125 may comprise an inorganic material such as SiNx, SiON, etc.

When forming the second bank 125 after forming the first organic light-emitting element 140r and the second organic light-emitting element 140g, and the second bank 125 is an organic material, the temperature cannot be increased above 80 to 100 °C in order not to affect the lifespan of the first organic light-emitting element 140r and the second organic light-emitting element 140g. In this instance, the organic component may leak from the resin fired at 100° C or lower, which may affect the lifespan of the third organic light-emitting element 140b. Therefore, it may be preferable that the second bank 125 be made of an inorganic material.

Although not illustrated, when the second bank 125 is formed of black resin, the color viewing angle and visibility can be improved. In this instance, the black resin may be covered with an inorganic film to prevent leakage of the organic component.

Meanwhile, the plurality of organic light-emitting elements may comprise a first organic light-emitting element 140r, a second organic light-emitting element 140g, and a third organic light-emitting element 140b.

In the embodiment, since the first subpixel SPr, the second subpixel SPg, and the third subpixel SPb are disposed three-dimensionally, the first organic light-emitting element 140r, the second organic light-emitting element 140g, and the third organic light-emitting element 140b may also be disposed three-dimensionally.

The first organic light-emitting element 140r may be disposed in the first subpixel SPr. The first organic light-emitting element 140r may be disposed in the first subpixel SPr positioned on the first lateral surface SS1 of the three-dimensional structure 130. The second organic light-emitting element 140g may be disposed in the second subpixel SPg. The second organic light-emitting element 140g may be disposed in the second subpixel SPg positioned on the second lateral surface SS2 of the three-dimensional structure 130. The third organic light-emitting element 140b may be disposed in the third subpixel SPb. The third organic light-emitting element 140b may be disposed on the upper surface TS of the three-dimensional structure 130. The third organic light-emitting element 140b may be disposed in the third subpixel SPb positioned on the upper surface TS of the three-dimensional structure 130.

The first organic light-emitting element 140r and the second organic light-emitting element 140g may be disposed to overlap each other horizontally with the three-dimensional structure 130 therebetween. The third organic light-emitting element 140b may be disposed on the first organic light-emitting element 140r and the second organic light-emitting element 140g.

The first organic light-emitting element 140r and the second organic light-emitting element 140g may be disposed on the protective layer 110, and the third organic light-emitting element 140b may be disposed on the second inorganic insulating layer 151. The first organic light-emitting element 140r and the second organic light-emitting element 140g may be disposed under the first inorganic insulating layer 150.

One of the first organic light-emitting element 140r and the second organic light-emitting element 140g may comprise a red organic light-emitting element, and the other may comprise a green organic light-emitting element. The third organic light-emitting element 140b may comprise a blue organic light-emitting element.

In the top emission method, the first color light, the second color light, and the third color light generated from the first organic light-emitting element 140r, the second organic light-emitting element 140g, and the third organic light-emitting element 140b, respectively, may be emitted toward the front side through the third inorganic insulating layer 153. For example, the first color light may be red light, the second color light may be green light, and the third color light may be blue light, but is not limited thereto.

Meanwhile, the first organic light-emitting element 140r may comprise a first anode electrode 141r, a first organic emission layer 142r, a first cathode electrode 143r, etc. The second organic light-emitting element 140g may comprise a second anode electrode 141g, a second organic emission layer 142g, a second cathode electrode 143g, etc. The third organic light-emitting element 140b may comprise a third anode electrode 141b, a third organic emission layer 142b, a third cathode electrode 143b, etc. The first organic emission layer 142r may generate a first color light using power between the first anode electrode 141r and the first cathode electrode 143r, the second organic emission layer 142g may generate a second color light using power between the second anode electrode 141g and the second cathode electrode 143g, and the third organic emission layer 142b may generate a third color light using power between the third anode electrode 141b and the third cathode electrode 143b.

The first anode electrode 141r, the second anode electrode 141g, and the third anode electrode 141b may be independently disposed in the first subpixel SPr, the second subpixel SPg, and the third subpixel SPb. That is, the first anode electrode 141r may be disposed only in the first subpixel SPr, the second anode electrode 141g may be disposed only in the second subpixel SPg, and the third anode electrode 141b may be disposed only in the third subpixel SPb.

As an example, a conductive material may be formed and patterned on the substrate 100, so that the first anode electrode 141r, the second anode electrode 141g, and the third anode electrode 141b may be independently formed in the first subpixel SPr, the second subpixel SPg, and the third subpixel SPb, respectively.

The plurality of first anode electrodes 141r and the plurality of second anode electrodes 141g may be disposed to be spaced apart from each other with the plurality of first banks 120 interposed therebetween. The plurality of third anode electrodes 141b may be disposed to be spaced apart from each other with the plurality of second banks 125 interposed therebetween.

The first anode electrode 141r may be electrically connected to the first driving circuit 101r. Since the first anode electrode 141r and the first driving circuit 101r are disposed with the protective layer 110 interposed therebetween, the first anode electrode 141r may be electrically connected to the first driving circuit 101r through the protective layer 110.

The second anode electrode 141g may be electrically connected to the second driving circuit 101g. Since the second anode electrode 141g and the second driving circuit 101g are disposed with the protective layer 110 therebetween, the second anode electrode 141g may be electrically connected to the first driving circuit 101r through the protective layer 110.

The first anode electrode 141r and the second anode electrode 141g may be electrically connected to the first driving circuit and the second driving circuit through the auxiliary electrodes 111. The auxiliary electrode 111 may be disposed on the protective layer 110 and may be electrically connected to the first driving circuit and the second driving circuit by penetrating the protective layer 110.

The third anode electrode 141b may be electrically connected to the third driving circuit 101b through a connecting part (not illustrated). The third anode electrode 141b may be electrically connected to the third driving circuit 101b in a non-emission region between the first subpixel SPr and the second subpixel SPg or in a non-emission region between the adjacent pixels P. For example, the third anode electrode 141b may be electrically connected to the third driving circuit 101b through a plurality of insulating layers 150, 160, and 151, the first bank 120, and the protective layer 110.

The cathode electrodes 143r and 143g may be disposed on the entire region of the substrate. At this time, the cathode electrode included in the first subpixel SPr may be the first cathode electrode 143r, and the cathode electrode included in the second subpixel SPg may be the second cathode electrode 143g.

When the cathode electrodes 143r and 143g are disposed on the entire region of the substrate, and the connecting electrode (or auxiliary electrode) between the third anode electrode 141b and the third driving circuit 101b penetrates through the multiple insulating layers 150, 160, and 151, the first bank 120, and the protective layer 110, an electrical short may occur between the connecting electrode and the cathode electrodes 143r and 143g. To prevent this, a through hole may be formed in the cathode electrodes 143r and 143g so as to be physically separated from the connecting electrode. In addition, an insulating layer may be formed between the connecting electrode and the cathode electrodes 143r and 143g in the through hole of the cathode electrodes 143r and 143g, but is not limited thereto.

In the top emission method having a large area screen of 15" or more, the cathode electrodes 143r and 143g may be made of a low-resistance material because they are thin, and the power line may be disposed in the display region. In this instance, the cathode electrodes 143r and 143g may be connected to the power line through the EVSS electrode (auxiliary electrode). The third cathode electrode 143b may be connected to the same power line by penetrating the plurality of insulating layers 150, 160, and 151.

In the case of a small area screen of 15" or less, it may be directly connected to the power line provided in the non-display region around the display region. For example, in a deposition process, in a cell metal mask distinguished into panel units, the power line and the organic emission layers 142r, 142g, and 142b may be covered so as not to be deposited, and the cathode electrodes 143r, 143g, and 143b may be opened so as to be deposited, so that the cathode electrodes 143r, 143g, and 143b may be electrically connected to the power line.

When the third cathode electrode 143 is connected to the power line through a plurality of insulating layers 150, 160, and 151, the EVSS electrode (auxiliary electrode) may be disposed as an intermediate layer on the same layer as the anode electrode 141b of the third subpixel SPb. In this instance, since the third cathode electrode 143 is connected to the power line through the EVSS electrode (auxiliary electrode), reliability can be improved.

Meanwhile, as illustrated in FIGS. 1 and 2, each of the first subpixel SPr, the second subpixel SPg, and the third subpixel SPb may comprise an emission region EAr, EAg, and EAb and a non-emission region. In this instance, the first emission region EAr of the first subpixel SPr may have a size corresponding to the first anode electrode 141r. The second emission region EAg of the second subpixel SPg may have a size corresponding to the second anode electrode 141g. The third emission region EAb of the third subpixel SPb may have a size corresponding to the third anode electrode 141b.

As illustrated in FIG. 2, the third anode electrode 141b may be disposed on an upper side of the first anode electrode 141r and an upper side of the second anode electrode 141g.

The first organic emission layer 142r, the second organic emission layer 142g, and the third organic emission layer 142b may be independently disposed in the first subpixel SPr, the second subpixel SPg, and the third subpixel SPb. That is, the first organic emission layer 142r may be disposed only in the first subpixel SPr, and the second organic emission layer 142g may be disposed only in the second subpixel SPg.

The first organic emission layer 142r may be disposed on the first anode electrode 141r in the first subpixel SPr, the second organic emission layer 142g may be disposed on the second anode electrode 141g in the second subpixel SPg, and the third organic emission layer 142b may be disposed on the third anode electrode 141b in the third subpixel SPb. The first organic emission layer 142r may be disposed on a part of an upper side of the first bank 120 positioned on each of both sides of the first subpixel SPr. The second organic emission layer 142g may be disposed on a part of an upper side of the first bank 120 positioned on each of both sides of the second subpixel SPg. The first organic emission layer 142r and the second organic emission layer 142g may be disposed to be spaced apart from each other on the upper side of the first bank 120. The third organic emission layer 142b may be disposed on a part of an upper side of the second bank 125 positioned on each of both sides of the third subpixel SPb.

The third organic emission layer 142b may be disposed only on a region corresponding to the third subpixel SPb on the second inorganic insulating layer 151, and may not be disposed on a region corresponding to the first subpixel SPr or the second subpixel SPg. Accordingly, since the third color light of the third organic emission layer 142b is not generated in a region corresponding to the first subpixel SPr or the second subpixel SPg in the second inorganic insulating layer 151, the first color light generated in the first organic light-emitting element 140r or the second color light generated in the second organic light-emitting element 140g may be emitted toward the front side without being interfered with by the third color light.

The second bank 125 may be formed of black resin. That is, the second bank 125 may be called a black layer, a black matrix, etc.

Although not illustrated, when the second bank 125 is formed of black resin, the color viewing angle and visibility can be improved. In this instance, the black resin may be covered with an inorganic film to prevent leakage of the organic component.

Meanwhile, the first cathode electrode 143r and the second cathode electrode 143g may be disposed on the substrate 100. That is, the first cathode electrode 143r and the second cathode electrode 143g may be disposed integrally on the substrate 100 without being distinguished from each other. For example, the first cathode electrode 143r and the second cathode electrode 143g may be disposed commonly only in the first subpixel SPr and the second subpixel SPg as cathode electrodes.

The third cathode electrode 143b may be disposed only in the third subpixel SPb. That is, the third cathode electrode 143b may not be disposed between the plurality of third subpixels SPb. For example, the third cathode electrode 143b may not be disposed between the plurality of third subpixels SPb on the second inorganic insulating layer 151.

Therefore, the third organic emission layer 142b, the third cathode electrode 143b, the second bank 125, etc. are not disposed on the remaining region except a region corresponding to the third subpixel SPb on the second inorganic insulating layer 151, so that the number of layers can be minimized. Accordingly, the first color light of the first organic light-emitting element 140r and the second color light of the second organic light-emitting element 140g may be emitted toward the front side without light loss, so that the lifetime luminous efficacy can be improved.

Meanwhile, in the embodiment, the first anode electrode 141r and the second anode electrode 141g may each comprise a reflective electrode having excellent reflective characteristics. In this instance, each of the first color light generated from the first organic emission layer 142r and the second color light generated from the second organic emission layer 142g may be reflected by the first anode electrode 141r and the second anode electrode 141g and emitted toward the front side, so that the light extraction efficiency can be increases and the image quality can be improved.

In the embodiment, the first cathode electrode 143r and the second cathode electrode 143g may comprise a transparent or translucent conductive film.

When the first cathode electrode 143r and the second cathode electrode 143g each comprise a translucent conductive film, recycling of the first color light may occur between the first anode electrode 141r and the first cathode electrode 143r and between the second anode electrode 141g and the second cathode electrode 143g, so that the light extraction efficiency can be improved. That is, the first color light generated in the first organic emission layer 142r may be reflected by the first cathode electrode 143r and may travel in a downward direction, and may be reflected again by the first anode electrode 141r and travel in an upward direction. Some of the first color light that travels in an upward direction may transmit through the first cathode electrode 143r and be emitted toward the front side, and another light may be reflected by the first cathode electrode 143r. In this way, since the first color light is recycled between the first cathode electrode 143r and the first anode electrode 141r, more of the first color light can be emitted toward the front side, thereby improving the light-emitting efficiency.

Similarly, since the second color light generated from the second organic emission layer 142g is recycled between the second cathode electrode 143g and the second anode electrode 141g, more second color light can be emitted toward the front side, thereby improving the light-emitting efficiency.

Meanwhile, referring to FIGS. 1 and 2, a plurality of insulating layers 150 to 153, 160, and 161 may be disposed on the substrate 100. The plurality of insulating layers may comprise at least one or more inorganic insulating layers 150 to 153 and at least one or more organic insulating layers 160 and 161. For example, the inorganic insulating layer may comprise SiNx, SiO₂, etc., but is not limited thereto.

Among the plurality of insulating layers 150, 160, and 151 disposed between the first organic light-emitting element 140r and the third organic light-emitting element 140b, the lowermost layer 150 and the uppermost layer 151 may be inorganic insulating layers. For example, the plurality of insulating layers may comprise, but are not limited to, a first inorganic insulating layer 150, a first organic insulating layer 160, a second inorganic insulating layer 151, etc. At least one of the first inorganic insulating layer 150, the first organic insulating layer 160, and the second inorganic insulating layer 151 may be omitted. The first organic insulating layer 160 may be disposed between the first inorganic insulating layer 150 and the second inorganic insulating layer 151. The first inorganic insulating layer 150 and the second inorganic insulating layer 151 may each comprise a plurality of insulating films.

The first inorganic insulating layer 150 may be disposed on the first organic light-emitting element 140r and the second organic light-emitting element 140g. The first inorganic insulating layer 150 may be disposed on an upper side of the first cathode electrode 143r of the first organic light-emitting element 140r and an upper side of the second cathode electrode 143g of the second organic light-emitting element 140g. The first inorganic insulating layer 150 may prevent moisture, oxygen, etc. from penetrating into the first organic emission layer 142r under the first cathode electrode 143r and the second organic emission layer 142g under the second cathode electrode 143g.

The second inorganic insulating layer 151 may be disposed under the third organic light-emitting element 140b. The second inorganic insulating layer 151 may be disposed under the third anode electrode 141b of the third organic light-emitting element 140b. The second inorganic insulating layer 151 may prevent moisture, oxygen, etc. from penetrating into the third organic emission layer 142b above the third anode electrode 141b.

Meanwhile, an insulating pattern 152 may comprise a multilayer inorganic film disposed on a capping layer CPL to protect the third cathode electrode 143b and the third organic emission layer 142b. The multilayer inorganic film may prevent the penetration of a developer solution in the exposure process and the developing process during the patterning process.

In addition, an inorganic film may be provided instead of the second organic insulating layer 161, or a multilayer structure comprising an inorganic film and an organic film may be provided. Accordingly, the penetration of the developer solution may be fundamentally blocked.

The third inorganic insulating layer 153 may be disposed on the third organic light-emitting element 140b. The third inorganic insulating layer 153 may be disposed on the third cathode electrode 143b of the third organic light-emitting element 140b. The third inorganic insulating layer 153 may prevent moisture, oxygen, etc. from penetrating into the third organic emission layer 142b under the third cathode electrode 143b.

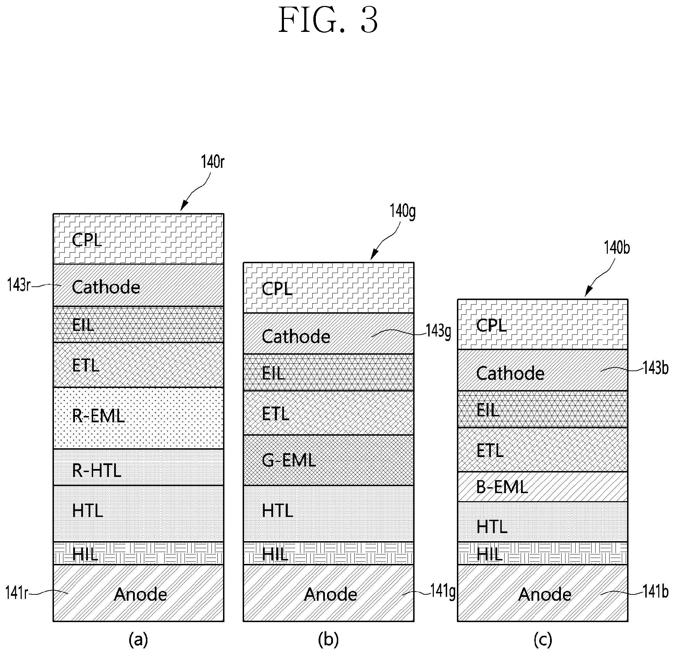

FIG. 3 illustrates a stacked structure for each organic light-emitting element. The stacked structure for each organic light-emitting element illustrated in FIG. 3 illustrates a 1-stack structure.

As illustrated in FIG. 3, the first organic light-emitting device 140r, the second organic light-emitting device 140g, and the third organic light-emitting device 140b may each comprise an anode electrode 141r, 141g, and 141b, a plurality of organic layers, a cathode electrode 143r, 143g, and 143b, and a capping layer CPL.

For example, a hole injection layer HIL, a hole transport layer HTL, an electron transport layer ETL, an electron injection layer EIL, etc. may be commonly included in the first organic light-emitting device 140r, the second organic light-emitting device 140g, and the third organic light-emitting device 140b. The hole injection layer HIL, the hole transport layer HTL, the electron transport layer ETL, the electron injection layer EIL, etc. may be commonly formed on the substrate 100.

For example, a red organic emission layer R-EML may be included in the first organic light-emitting element 140r, a green organic emission layer G-EML may be included in the second organic light-emitting element 140g, and a blue organic emission layer B-EML may be included in the third organic light-emitting element 140b. The red organic emission layer R-EML may be formed only in the first subpixel SPr on the substrate 100. The green organic emission layer G-EML may be formed only in the second subpixel SPg on the substrate 100. The blue organic emission layer B-EML may be formed only in the third subpixel SPb on the substrate 100.

For example, a red hole transport layer R-HTL may be included in the first organic light-emitting element 140r. A green hole transport layer may be included in the second organic light-emitting element 140g. The red hole transport layer R-HTL may be formed only in the first subpixel SPr on the substrate 100.

The stacked structure for each organic light-emitting element may also be applied to two or more stack structures.

In the two or more stack structures, a hole injection layer HIL, a hole transport layer HTL, a first organic emission layer, an electron transport layer ETL, an electron injection layer EIL, etc. may be disposed between the anode electrodes 141r, 141g, and 141b and a charge generation layer, and a hole transport layer HTL, a second organic emission layer, an electron transport layer ETL, an electron injection layer EIL, etc. may be disposed between the charge generation layer and the cathode electrodes 143r, 143g, and 143b.

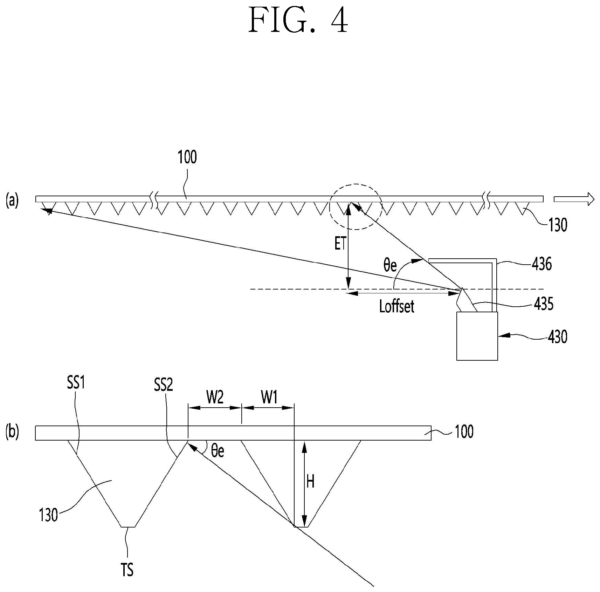

FIG. 4 schematically illustrates the design structure of the three-dimensional structure and the design structure of the second evaporation source device. In FIG. 4, for convenience of explanation, the deposition of the green emitting layer G-EML is illustrated, but it may be similarly applied to the deposition of the red emitting layer G-EML.

As illustrated in FIG. 4, a green light-emitting material of a second evaporation source device 430 may be deposited on a second lateral surface SS2 of the three-dimensional structure 130, so that the second organic light-emitting element 140g may be formed on the second lateral surface SS2. The second evaporation source device 430 may be installed in a second deposition chamber.

Although not illustrated, a red light-emitting material of a first evaporation source device may be deposited on a first lateral surface SS1 of the three-dimensional structure 130, so that the first organic light-emitting element 140r may be formed on the first lateral surface SS1. The first evaporation source device may be installed in a first deposition chamber.

Key factors in the design of the three-dimensional structure 130 comprise a height H, a first width W1, a second width W2, etc. The height H may be a height of the three-dimensional structure 130. The first width W1 may be a width projected vertically with respect to the first lateral surface SS1 of the three-dimensional structure 130. The second width W2 may be a width of a separation region between the adjacent three-dimensional structures 130.

A deposition angle θe (or maximum deposition angle) for depositing a green light-emitting material on the second lateral surface SS2 by a shadow effect may be expressed by mathematical equation 1.$tanθe = H / \left(W1+W2\right)$

A virtual line may correspond to the deposition angle θe of mathematical expression 1. The virtual line may be drawn by connecting one end of the upper surface TS of the three-dimensional structure 130 to one end of the effective emission region of the first subpixel SPr with respect to the plane of the substrate 100.

Meanwhile, the second evaporation source device 430 for deposition relative to the second lateral surface SS2 of the three-dimensional structure 130 may be disposed to satisfy the deposition angle θe.

In this regard, an angle limiting plate 436 may be disposed between the second evaporation source device 430 comprising the green light-emitting material and the substrate 100 in the second deposition chamber.

The angle limiting plate 436 may be configured to have a width substantially wider than a width of the second evaporation source device 430 so as to cover an entire region of the second evaporation source device 430.

Meanwhile, the nozzle 435 of the second evaporation source device 430 may be installed so as to be inclined so as to face the second lateral surface SS2.

The second evaporation source device 430 and the angle limiting plate 436 may be disposed so that a virtual line connecting the nozzle 435 and the rear end (i.e., one end in the deposition direction) of the angle limiting plate 436 becomes a deposition angle θe. This may be expressed by mathematical equation 2.$tanθe = ET / Loffset$

ET represents a vertical distance between the substrate 100 and the second evaporation source device 430 (more specifically, the nozzle 435), and Loffset may represent the shortest horizontal distance from the second evaporation source device 430 to the substrate 100 where the green light-emitting material may be deposited.

It is preferable to design the three-dimensional structure 130 and the second evaporation source device 430 so that mathematical formulas 1 and 2 are satisfied.

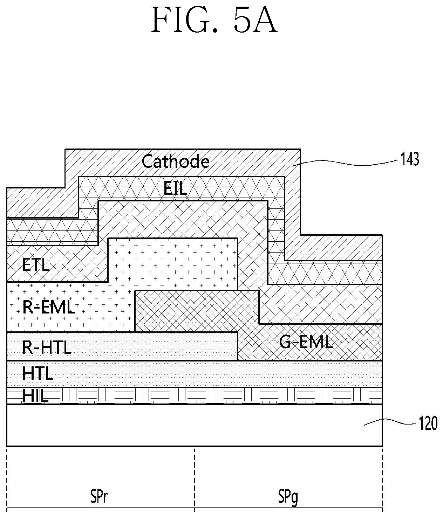

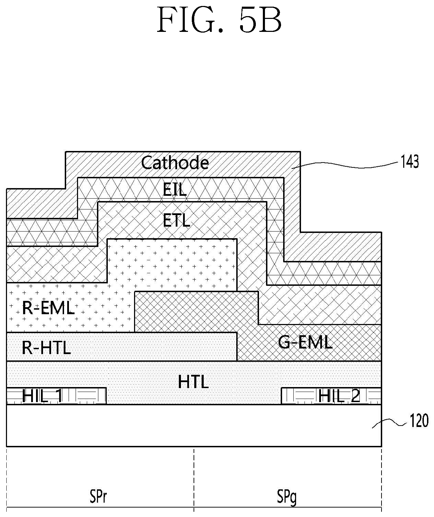

FIGS. 5A and 5B illustrate a first organic light-emitting element and a second organic light-emitting element disposed on a first bank between three-dimensional structures according to the comparative example and the embodiment. FIGS. 5A and 5B are enlarged views of a region J of FIG. 2.

As illustrated in FIGS. 2 and 5A, a hole injection layer HIL, a hole transport layer HTL, a red hole transport layer R-HTL, a green organic emitting layer G-EML, a red organic emitting layer R-EML, an electron transport layer ETL, an electron injection layer EIL, a cathode electrode 143, etc. may be disposed on the first bank 120. Here, the cathode electrode 143 may be a first cathode electrode 141r of the first organic emitting element 140r and/or a second cathode electrode 141g of the second organic emitting element 140g.

The red hole transport layer R-HTL and the red organic emitting layer R-EML may be disposed on one side region of the first bank 120, and the green organic emitting layer G-EML may be disposed on the other side region of the first bank 120. The green organic emitting layer G-EML may be vertically overlapped with each of the red hole transport layer R-HTL and the red organic emitting layer R-EML. The green organic light-emitting layer G-EML may be vertically disposed between the red hole transport layer R-HTL and the red organic light-emitting layer R-EML.

The hole injection layer HIL, the hole transport layer HTL, the electron transport layer ETL, the electron injection layer EIL, and the cathode electrode 143 may be disposed on the entire region of the first bank 120.

The hole injection layer HIL may be made of a low-resistance organic material, and the hole injection layer of the first organic light-emitting element 140r and the hole injection layer of the second organic light-emitting element 140g may be connected to each other on the first bank 120, so that a transverse current leakage may occur between the first subpixel SPr and the second subpixel SPg. If leakage emission due to the transverse current leakage occurs, problems such as a decrease in yield due to color spot may occur.

To solve these problems, as illustrated in FIG. 2 and FIG. 5B, the hole injection layers HIL1 and HIL2 may be disposed to be spaced apart from each other on the first bank 120. Accordingly, the hole injection layer HIL1 of the first organic light-emitting element 140r and the hole injection layer HIL2 of the second organic light-emitting element 140g may be cut off on the first bank 120, thereby preventing the transverse current leakage between the first subpixel SPr and the second subpixel SPg.

As illustrated in FIG. 4, when a plurality of organic layers are deposited to form the second organic light-emitting element 140g, the hole injection layer HIL2, which is a low-resistance organic material, and the green organic emission layer G-EML, which is a high-resistance organic material, may be adjusted to be sprayed toward the substrate 100 at different deposition angles. For example, since the deposition angle of the hole injection layer HIL2 is set smaller than the deposition angle of the green organic emission layer G-EML with respect to the horizontal line, the end of the hole injection layer HIL2 may be positioned closer to a lateral surface of the first bank 120 than the end of the green organic emission layer G-EML.

The hole injection layer HIL2 may be called a low-resistance layer, and the green organic emission layer G-EML, etc. may be called a high-resistance layer.

Although not illustrated, when a plurality of organic layers are deposited to form the first organic light-emitting element 140r, the hole injection layer HIL1, which is a low-resistance organic material, and the red organic emission layer R-EML, which is a high-resistance organic material, may be adjusted to be sprayed toward the substrate 100 at different deposition angles. For example, since the deposition angle of the hole injection layer HIL1 is set smaller than the deposition angle of the red organic emission layer R-EML with respect to the horizontal line, the end of the hole injection layer HIL1 may be positioned closer to a lateral surface of the first bank 120 than the end of the red organic emission layer R-EML.

Accordingly, the end of the hole injection layer HIL1 of the first organic light-emitting element 140r and the end of the hole injection layer HIL2 of the second organic light-emitting element 140g may be disposed to be spaced apart from each other.

Meanwhile, when the organic light-emitting elements, each having two or more stack structures are applied, since the charge generation layer disposed between a first stack and a second stack is also a low-resistance organic material, the charge generation layers may be disposed to be spaced apart from each other on the first bank 120.

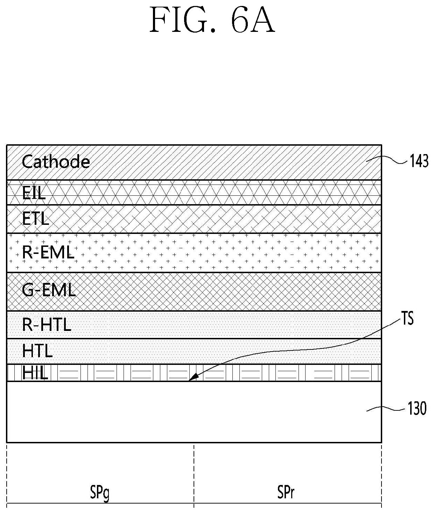

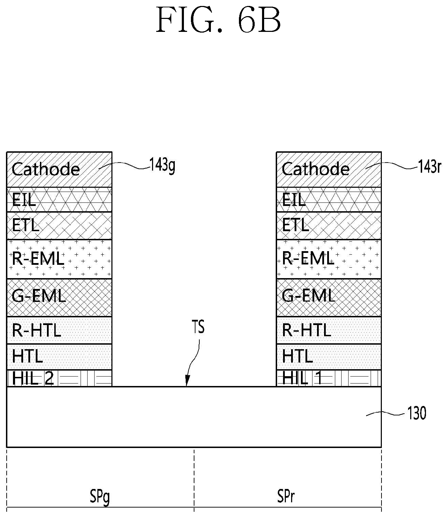

FIGS. 6A and 6B illustrate a first organic light-emitting element and a second organic light-emitting element disposed on an upper surface of a three-dimensional structure according to the comparative example and the embodiment. FIGS. 6A and 6B are enlarged views of the K region of FIG. 2.

As illustrated in FIG. 2 and FIG. 6A, a hole injection layer HIL, a hole transport layer HTL, a red hole transport layer R-HTL, a green organic emission layer G-EML, a red organic emission layer R-EML, an electron transport layer ETL, an electron injection layer EIL, a cathode electrode 143, etc. may be disposed on the upper surface TS of the three-dimensional structure 130.

The hole injection layer HIL, the hole transport layer HTL, the electron transport layer ETL, the electron injection layer EIL, and the cathode electrode 143 may be disposed on the entire region of the first bank 120.

In particular, since the hole injection layer HIL, which is a low-resistance organic material, is disposed on the entire region of the first bank 120, the hole injection layer of the first organic light-emitting element 140r and the hole injection layer of the second organic light-emitting element 140g may be connected to each other on the upper surface TS of the three-dimensional structure 130. Accordingly, a transverse current leakage may occur between the first subpixel SPr and the second subpixel SPg.

In order to solve this problem, as illustrated in FIG. 2 and FIG. 6B, the cathode electrode 143 and the plurality of organic layers disposed on the upper surface TS of the three-dimensional structure 130 may be removed using a patterning process. That is, the cathode electrode 143 and the plurality of organic layers may be removed so that the upper surface TS of the three-dimensional structure 130 may be exposed. Accordingly, since the hole injection layer HIL1 of the first organic light-emitting element 140r and the hole injection layer HIL2 of the second organic light-emitting element 140g are cut off from each other on the upper surface TS of the three-dimensional structure 130, the transverse current leakage between the first subpixel SPr and the second subpixel SPg can be prevented.

Meanwhile, when the organic light-emitting elements, each having two or more stack structures are applied, the charge generation layers disposed between the first stack and the second stack may be disposed to be spaced apart from each other on the upper surface TS of the three-dimensional structure 130.

### [Second Embodiment]

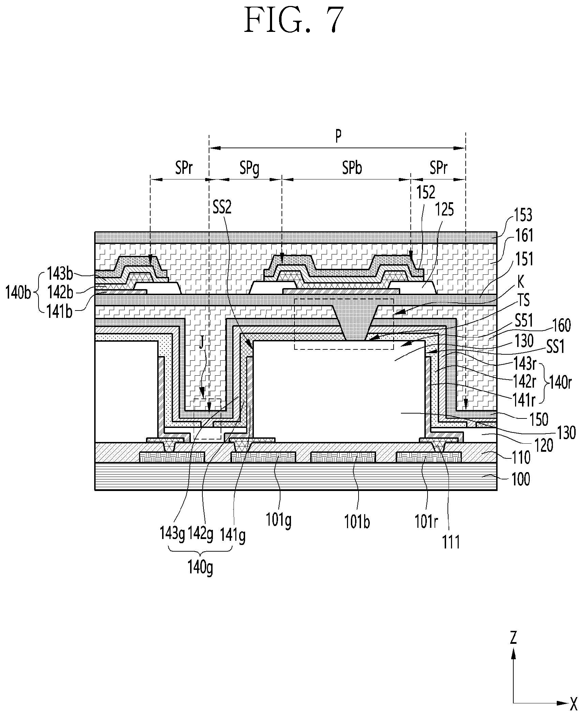

FIG. 7 is a cross-sectional view illustrating an organic light-emitting display device according to a second embodiment. FIG. 7 is a cross-sectional view taken along the line A-A' of the organic light-emitting display device of FIG. 1.

The second embodiment is the same as the first embodiment (FIG. 2) except that the first lateral surface SS1 and the second lateral surface SS2 of the three-dimensional structure 130 are each perpendicular to the substrate 100. In the second embodiment, components having the same structure, shape, and/or function as those of the first embodiment (FIG. 2) are given the same drawing reference numerals, and detailed descriptions thereof will be omitted.

Referring to FIG. 1 and FIG. 7, the organic light-emitting display device according to a second embodiment may comprise a substrate 100, a plurality of driving circuits 101r, 101g and 101b, a protective layer 110, a plurality of three-dimensional structures 130, a plurality of banks 120 and 125, a plurality of organic light-emitting elements 140r, 140g and 140b, a plurality of insulating layers 150 to 153, 160 and 161, etc.

The first lateral surface SS1 and the second lateral surface SS2 of the three-dimensional structure 130 may be each perpendicular to the substrate 100. For example, the first lateral surface SS1 and the second lateral surface SS2 of the three-dimensional structure 130 may each be at 90 degrees with respect to the substrate 100. In this instance, the first organic light-emitting element 140r may be disposed in the first subpixel SPr on the first lateral surface SS1 of the three-dimensional structure 130, and the second organic light-emitting element 140g may be disposed in the second subpixel SPg on the second lateral surface SS2 of the three-dimensional structure 130.

Since the first lateral surface SS1 and the second lateral surface SS2 of the three-dimensional structure 130 are each perpendicular to the substrate 100, the occupied area of the first organic light-emitting element 140r and the occupied area of the second organic light-emitting element 140g can be minimized when viewed from the front side, so that an ultra-high-resolution display can be implemented.

In contrast, since the first lateral surface SS1 and the second lateral surface SS2 of the three-dimensional structure 130 are secured as the emission regions of the first subpixel SPr and the second subpixel SPg, respectively, the first color light and the second color light may be sufficiently emitted toward the front side, so that a decrease in the lifetime luminous efficacy can be prevented.

The transverse current leakage prevention structure illustrated in FIG. 6B may be applied to FIG. 7. That is, since the low-resistance layer of the first organic light-emitting element 140r and the low-resistance layer of the second organic light-emitting element 140g are cut off from each other on the upper surface TS of the three-dimensional structure 130, the transverse current leakage between the first subpixel SPr and the second subpixel SPg can be prevented. The low-resistance layer may comprise, for example, a hole injection layer, a charge generation layer, etc.

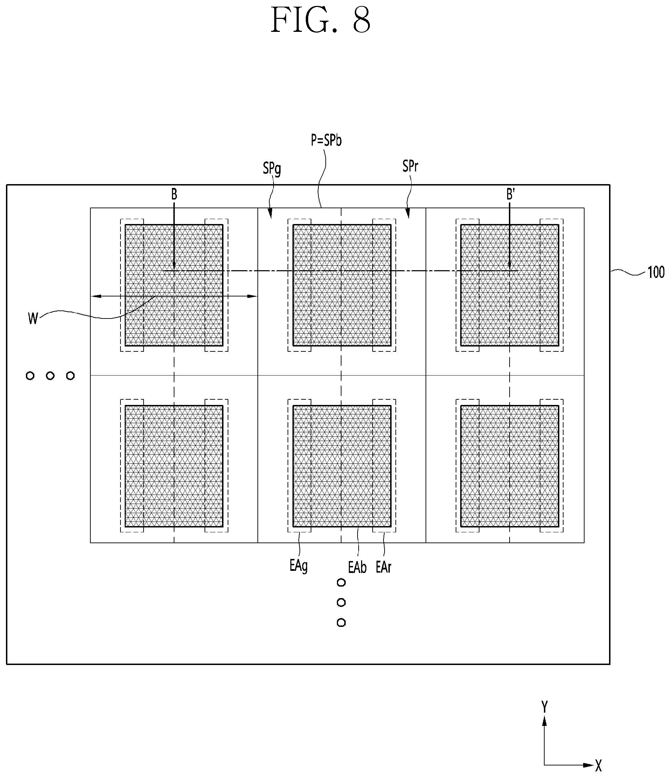

FIG. 8 is a plan view illustrating an organic light-emitting display device according to a second embodiment. The second embodiment may be the same as the first embodiment (FIG. 1) except that the third subpixel SPb vertically overlaps the first subpixel SPr and the second subpixel SPg. In the second embodiment, components having the same structure, shape, and/or function as those of the first embodiment (FIG. 1) are given the same drawing reference numerals, and detailed descriptions thereof will be omitted.

In the first embodiment (FIG. 1), the first subpixel SPr, the second subpixel SPg, and the third subpixel SPb may not be vertically overlapped with each other. In contrast, in the second embodiment (FIG. 8), the first subpixel SPr, the second subpixel SPg, and the third subpixel SPb may be vertically overlapped with each other.

In the embodiment, the plurality of pixels P may each comprise a first subpixel SPr, a second subpixel SPg, and a third subpixel SPb having a three-dimensional structure. That is, the first subpixel SPr, the second subpixel SPg, and the third subpixel SPb may be disposed three-dimensionally, thereby configuring the pixel P. That is, the first subpixel SPr, the second subpixel SPg, and the third subpixel SPb may be disposed not only horizontally but also vertically with respect to each other, thereby configuring the pixel P.

For example, a sum of a size (or area) of the first subpixel SPr and a size (or area) of the second subpixel SPg may be equal to a size (or area) of the pixel P. For example, a sum of a width of the first subpixel SPr and a width of the second subpixel SPg may be equal to a width W of the pixel P.

For example, a size (or area) of the third subpixel SPb may be equal to the size (or area) of the pixel P. For example, a width of the third subpixel SPb may be equal to the width W of the pixel P.

In this instance, the first subpixel SPr, the second subpixel SPg, and the third subpixel SPb may be disposed three-dimensionally so that the pixel P comprises all of the first subpixel SPr, the second subpixel SPg, and the third subpixel SPb. To this end, the second subpixel SPg may be disposed to overlap horizontally with the first subpixel SPr, and the third subpixel SPb may be disposed to overlap vertically with the first subpixel SPr and the second subpixel SPg.

According to the embodiment, the first subpixel SPr, the second subpixel SPg, and the third subpixel SPb may be disposed three-dimensionally to form the pixel P, so that the size of the pixel P can be further reduced, and a high-definition and ultra-high-resolution display can be implemented.

Meanwhile, as illustrated in FIG. 8, a third emission area EAb of the third subpixel SPb may be disposed to overlap vertically with a first emission area EAr of the first subpixel SPr. The third emission area EAb of the third subpixel SPb may be disposed to overlap vertically with a second emission area EAg of the second subpixel SPg. The first emission region EAr of the first subpixel SPr and the second emission region EAg of the second subpixel SPg may not be vertically overlapped. That is, the first emission region EAr of the first subpixel SPr and the second emission region EAg of the second subpixel SPg may be disposed to overlap horizontally.

The size of the third emission region EAb of the third subpixel SPb may be greater than the size of the first emission region EAr of the first subpixel SPr. The size of the third emission region EAb of the third subpixel SPb may be greater than the size of the second emission region EAg of the second subpixel SPg. Although the size of the first emission region EAr and the size of the second emission region EAg are illustrated as being the same in the drawing, they may be different from each other.

According to the embodiment, the size of the third emission region EAb of the third subpixel SPb may be increased to the size of the pixel P, so that the third emission region EAb can be greatly increased, and thus the lifetime luminous efficacy can be improved.

### [Third Embodiment]

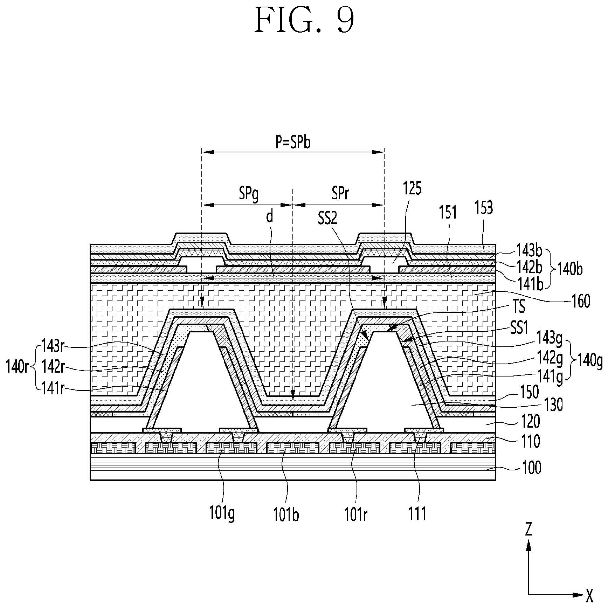

FIG. 9 is a cross-sectional view illustrating an organic light-emitting display device according to a third embodiment. FIG. 9 is a cross-sectional view taken along the line B-B' of the organic light-emitting display device of FIG. 8.

The third embodiment is similar to the first embodiment (FIG. 2) and the second embodiment (FIG. 7) except for the third organic light-emitting element 140b. In the third embodiment, components having the same structure, shape, and/or function as those of the first embodiment (FIG. 2) or the second embodiment (FIG. 7) are given the same drawing reference numerals and detailed descriptions thereof will be omitted.

Referring to FIGS. 8 and 9, the organic light-emitting display device according to a third embodiment may comprise a substrate 100, a plurality of driving circuits 101r, 101g, and 101b, a protective layer 110, a plurality of three-dimensional structures 130, a plurality of banks 120 and 125, a plurality of organic light-emitting elements 140r, 140g, and 140b, a plurality of insulating layers 150 to 153 and 160, etc.

In order to implement a high-definition and ultra-high-resolution display, the first subpixel SPr, the second subpixel SPg, and the third subpixel SPb may be disposed three-dimensionally. The third subpixel SPb may be disposed on the first subpixel SPr and may vertically overlap with the first subpixel SPr. The third subpixel SPb may be disposed on the second subpixel SPg, and may vertically overlap the second subpixel SPg.

The third subpixel SPb may be disposed on the first subpixel SPr and the second subpixel SPg between the plurality of three-dimensional structures 130.

The first organic light-emitting element 140r may be disposed in the first subpixel SPr, the second organic light-emitting element 140g may be disposed in the second subpixel SPg, and the third organic light-emitting element 140b may be disposed in the third subpixel SPb.

Since the first subpixel SPr, the second subpixel SPg, and the third subpixel SPb are disposed three-dimensionally, the first organic light-emitting element 140r, the second organic light-emitting element 140g, and the third organic light-emitting element 140b may also be disposed three-dimensionally.

The third organic light-emitting element 140b may be disposed on the upper sides of the first organic light-emitting element 140r and the second organic light-emitting element 140g, respectively, between the plurality of three-dimensional structures 130.

The second organic light-emitting element 140g may be disposed to overlap horizontally with the first organic light-emitting element 140r. The third organic light-emitting element 140b may be disposed to overlap vertically with the first organic light-emitting element 140r and the second organic light-emitting element 140g.

The first organic light-emitting element 140r and the second organic light-emitting element 140g may be disposed on the protective layer 110, and the third organic light-emitting element 140b may be disposed on the second inorganic insulating layer 151. Although not illustrated, the third organic light-emitting element 140b may be disposed on the first inorganic insulating layer 150.

One of the first organic light-emitting element 140r and the second organic light-emitting element 140g may comprise a red organic light-emitting element, and the other may comprise a green organic light-emitting element. The third organic light-emitting element 140b may comprise a blue organic light-emitting element.

In the top emission method, the first color light, the second color light, and the third color light generated from the first organic light-emitting element 140r, the second organic light-emitting element 140g, and the third organic light-emitting element 140b, respectively, may be emitted toward the front side through the third inorganic insulating layer 153. For example, the first color light may be red light, the second color light may be green light, and the third color light may be blue light, but this is not limited thereto.

Meanwhile, the first organic light-emitting element 140r may comprise a first anode electrode 141r, a first organic emission layer 142r, a first cathode electrode 143r, etc. The second organic light-emitting element 140g may comprise a second anode electrode 141g, a second organic emission layer 142g, a second cathode electrode 143g, etc. The third organic light-emitting element 140b may comprise a third anode electrode 141b, a third organic emission layer 142b, a third cathode electrode 143b, etc.

As illustrated in FIG. 8, each of the first subpixel SPr, the second subpixel SPg, and the third subpixel SPb may comprise an emission region EAr, EAg, and EAb and a non-emission region. In this instance, the first emission region EAr of the first subpixel SPr may have a size corresponding to the first anode electrode 141r. The second emission region EAg of the second subpixel SPg may have a size corresponding to the second anode electrode 141g. The third emission region EAb of the third subpixel SPb may have a size corresponding to the third anode electrode 141b.

As illustrated in FIG. 9, the third anode electrode 141b may be disposed on an upper side of the first anode electrode 141r and an upper side of the second anode electrode 141g. The third anode electrode 141b may vertically overlap the first anode electrode 141r and the second anode electrode 141g.

A size of the third anode electrode 141b may be greater than a size of the first anode electrode 141r. The size of the third anode electrode 141b may be greater than a size of the second anode electrode 141g. The size of the third anode electrode 141b may be equal to or greater than a sum of the sizes of the first anode electrode 141r and the second anode electrode 141g, but is not limited thereto.

According to an embodiment, in the third subpixel SPb having the same size as the size of the pixel P, the size of the third anode electrode 141b of the third organic light-emitting element 140b may be designed to be equal to or greater than the sum of the size of the first anode electrode 141r and the size of the second anode electrode 141g. Accordingly, the occupied area of the third emission region EAb of the third subpixel SPb within the pixel P may be maximized, so that the lifetime luminous efficacy of the third color light, i.e., blue light, can be increased, thereby improving the image quality.

The first anode electrode 141r, the second anode electrode 141g, and the third anode electrode 141b may be independently disposed in the first subpixel SPr, the second subpixel SPg, and the third subpixel SPb.

The first anode electrode 141r and the second anode electrode 141g may be electrically connected to the first driving circuit and the second driving circuit, respectively, through the auxiliary electrode 111. The third anode electrode 141b may be electrically connected to the third driving circuit 101b using a connecting part (not illustrated). For example, the third anode electrode 141b may be electrically connected to the third driving circuit 101b through the plurality of insulating layers 150, 160, and 151, the first bank 120, and the protective layer 110 via the connecting part.

The cathode electrodes 143r and 143g may be disposed on the entire region of the substrate 100, but are not limited thereto. The third cathode electrode 143b may be disposed on the entire region of the second inorganic insulating layer 151, but are not limited thereto.

The third organic emission layer 142b may be disposed on the entire region of the substrate 100, but is not limited thereto. That is, the third organic emission layer 142b may be disposed not only in the third subpixel SPb but also between the third subpixels SPb. For example, the third organic emission layer 142b may be disposed on the plurality of third anode electrodes 141b and the plurality of second banks 125.

According to an embodiment, since the organic light-emitting material forming the third organic emission layer 142b is deposited on the entire region of the substrate 100, there is no need to use a separate mask, such as FMM, so that the degree of process freedom can be increased and the yield can be improved.

The third cathode electrode 143b may be disposed on the entire region of the substrate 100, but is not limited thereto. The third cathode electrode 143b may be disposed on the plurality of third anode electrodes 141b and the plurality of second banks 125.

The third inorganic insulating layer 153 may be provided as a multilayer inorganic film on an upper surface of the third cathode electrode 143b, and, as in the first embodiment (FIG. 2), the second organic insulating layer 161 and the third inorganic insulating layer 153 may be provided.

Meanwhile, a plurality of first banks 120 may be disposed between a plurality of three-dimensional structures 130, and a plurality of second banks 125 may be disposed between a plurality of pixels P. The plurality of second banks 125 may be disposed on the upper surfaces TS of the plurality of three-dimensional structures 130.

When viewed from above, a plurality of first banks 120 may be positioned between a plurality of second banks 125.

A distance d between the plurality of second banks 125 may be a width W of the pixel P or a width of the third subpixel SPb.

The distance d between the plurality of second banks 125 may be equal to the sum of the width of the first subpixel SPr and the width of the second subpixel SPb, but is not limited thereto.

Meanwhile, although the first organic light-emitting element 140r and the second organic light-emitting element 140g are illustrated as being connected on the upper surface TS of the three-dimensional structure 130 in FIG. 9, they may be cut off from each other through a subsequent process.

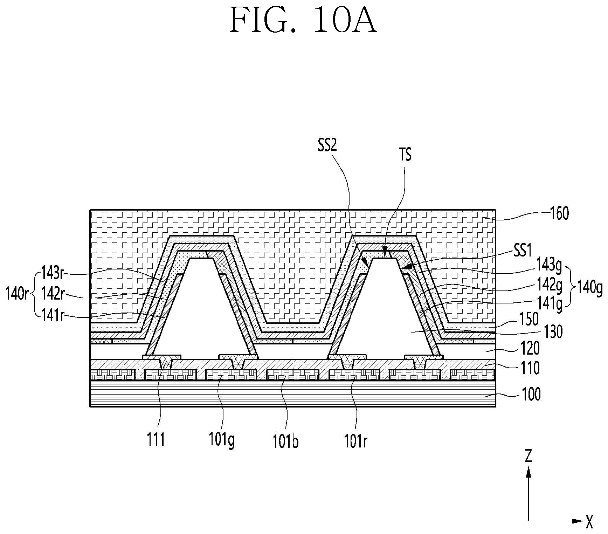

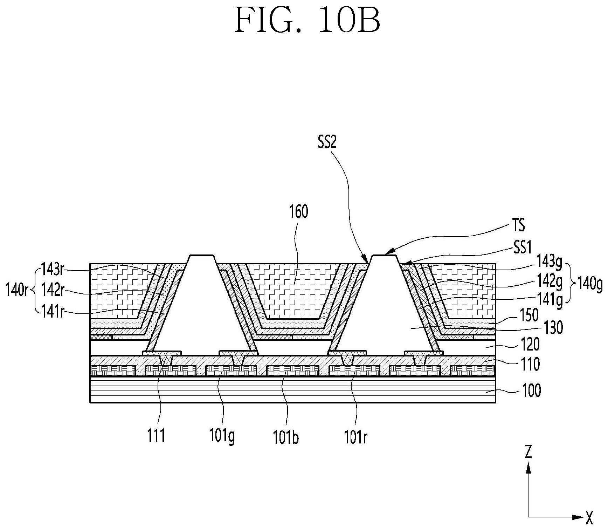

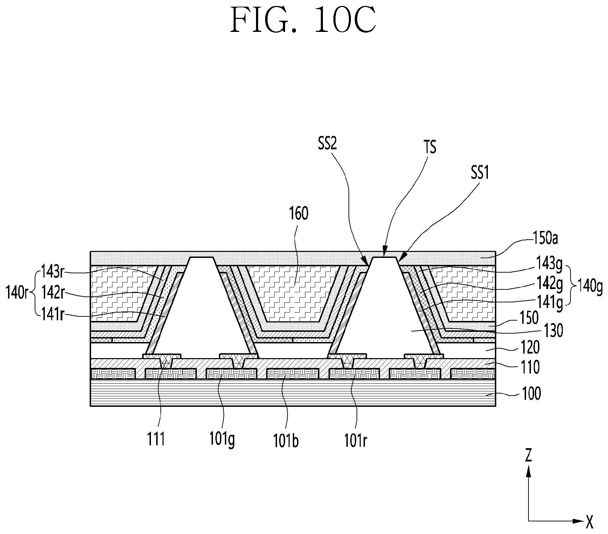

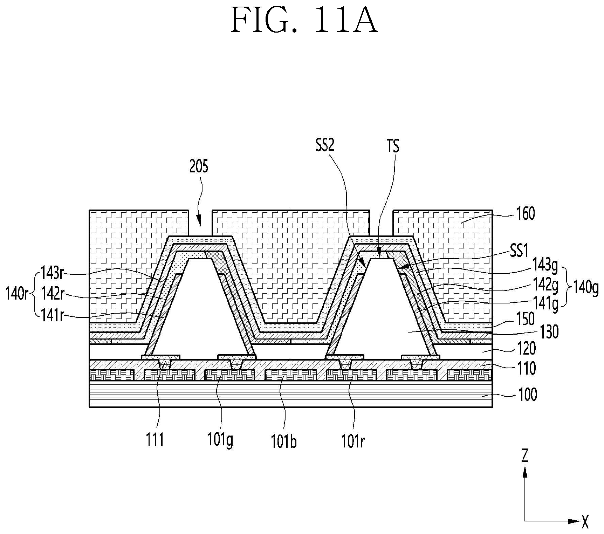

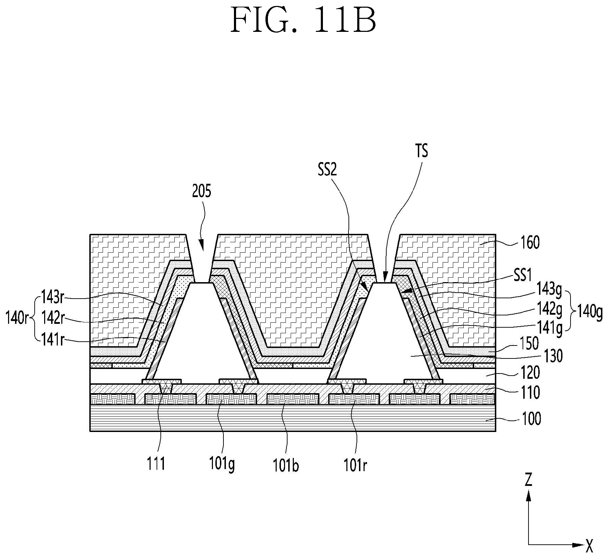

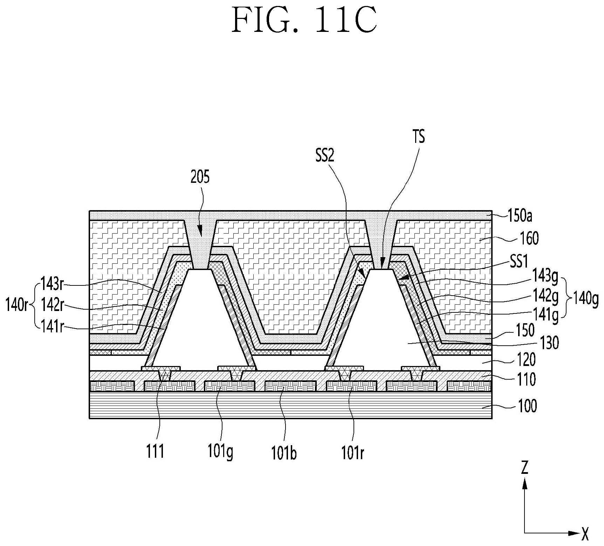

Referring to FIGS. 10 and 11, a process of cutting off the first organic light-emitting element and the second organic light-emitting element 140g from each other on the upper surface TS of the three-dimensional structure 130 will be described.

FIGS. 10A to 10C illustrate a manufacturing process according to a first embodiment for preventing a transverse current leakage.

As illustrated in FIG. 10A, a first organic light-emitting element 140r, a second organic light-emitting element 140g, a first inorganic insulating layer 150, a first organic insulating layer 160, etc. may be formed on a three-dimensional structure 130.

As illustrated in FIG. 10B, an ashing process may be performed so that the first organic insulating layer 160 may be removed so that an upper surface of the first inorganic insulating layer 150 may be exposed on the three-dimensional structure 130.

Thereafter, a dry etching process may be performed so that the first inorganic insulating layer 150, the first cathode electrode 143r and the first organic emission layer 142r of the first organic light-emitting element 140r, the second cathode electrode 143g and the second organic emission layer 142g of the second organic light-emitting element 140g may be removed. The dry etching process may be performed until the upper surface TS of the three-dimensional structure 130 is exposed. As a result of performing the dry etching process, the upper ends of the first cathode electrode 143r and the first organic emission layer 142r of the first organic light-emitting element 140r and the upper ends of the second cathode electrode 143g and the second organic emission layer 142g of the second organic light-emitting element 140g may be positioned lower than the upper surface TS of the three-dimensional structure 130.

As illustrated in FIG. 10C, an additional inorganic insulating layer 150a may be formed on the substrate 100. The additional inorganic insulating layer 150a may be referred to as a fourth inorganic insulating layer.

The additional inorganic insulating layer 150a may be formed on the exposed upper surface TS of the three-dimensional structure 130. The additional inorganic insulating layer 150a may be formed on the upper ends of the first cathode electrode 143r and the first organic emission layer 142r of the first organic light-emitting element 140r, respectively, and the upper ends of the second cathode electrode 143g and the second organic emission layer 142g of the second organic light-emitting element 140g, respectively. The additional inorganic insulating layer 150a may be formed on the first organic insulating layer 160.

Therefore, the first organic emission layer 142r of the first organic light-emitting element 140r and the second organic emission layer 142g of the second organic light-emitting element 140g may be spaced apart from each other with the three-dimensional structure 130 therebetween. In this instance, since the low-resistance layer of the first organic emission layer 142r and the low-resistance layer of the second organic emission layer 142g are spaced apart from each other with the three-dimensional structure 130 therebetween, the transverse current leakage between the first subpixel SPr and the second subpixel SPg can be prevented. The low-resistance layer may comprise, for example, a hole injection layer, a charge generation layer, etc.

FIGS. 11A to 11C illustrate a manufacturing process according to a second embodiment for preventing a transverse current leakage.

As illustrated in FIG. 11A, the first organic light-emitting element 140r, the second organic light-emitting element 140g, the first inorganic insulating layer 150, the first organic insulating layer 160, etc. may be formed on the three-dimensional structure 130.

Thereafter, a patterning process may be performed so that the first organic insulating layer 160 on the upper surface TS of the three-dimensional structure 130 may be removed, so that a contact hole 205 in which the upper surface of the first inorganic insulating layer 150 on the upper surface TS of the three-dimensional structure 130 is exposed may be formed. The contact hole 205 may be formed along the second direction (Y in FIG. 8) on the upper surface TS of the three-dimensional structure 130 between the first subpixel SPr and the second subpixel SPg.

As illustrated in FIG. 11B, a dry etching process may be performed to remove the first inorganic insulating layer 150, the first cathode electrode 143r and the first organic emission layer 142r of the first organic light-emitting element 140r, the second cathode electrode 143g and the second organic emission layer 142g of the second organic light-emitting element 140g on the three-dimensional structure 130. The dry etching process may be performed until the upper surface TS of the three-dimensional structure 130 is exposed.

The photosensitive pattern of the dry etching process may be the same as the photosensitive pattern used in the patterning process. Accordingly, when a dry etching process is performed, the first inorganic insulating layer 150, the first cathode electrode 143r and the first organic emission layer 142r of the first organic light-emitting element 140r, the second cathode electrode 143g and the second organic emission layer 142g of the second organic light-emitting element 140g may be removed through the dry etching process through the contact hole 205.

As illustrated in FIG. 11C, an additional inorganic insulating layer 150a may be formed on the substrate 100. The additional inorganic insulating layer 150a may be formed on the upper surface of the first organic insulating layer 160 and the contact hole 205.

Accordingly, the first organic emission layer 142r of the first organic light-emitting element 140r and the second organic emission layer 142g of the second organic light-emitting element 140g may be spaced apart from each other with the three-dimensional structure 130 therebetween. In this instance, since the low-resistance layer of the first organic emission layer 142r and the low-resistance layer of the second organic emission layer 142g are spaced apart from each other with the three-dimensional structure 130 therebetween, a transverse current leakage between the first subpixel SPr and the second subpixel SPg can be prevented. The low-resistance layer may comprise, for example, a hole injection layer, a charge generation layer, etc.

Meanwhile, as illustrated in FIGS. 11B and 11C, the first organic emission layer 142r of the first organic light-emitting element 140r and the second organic emission layer 142g of the second organic light-emitting element 140g may be removed through a dry etching process. At this time, when the three-dimensional structure 130 is made of an organic material, the upper surface TS of the three-dimensional structure 130 may be over-etched. In addition, the three-dimensional structure 130 may be made of a black resin to prevent light leakage.

In this instance, the organic component of the three-dimensional structure 130 may affect the lifespan of the first organic emission layer 142r of the first organic light-emitting element 140r or the second organic emission layer 142g of the second organic light-emitting element 140g. In addition, when the thickness of each of the first anode electrode 141r and the second anode electrode 141g is 500 Å or thicker, current concentration may occur at the upper end or corner of each of the first anode electrode 141r and the second anode electrode 141g. An electrical short may occur between the anode and the cathode during long-term operation.

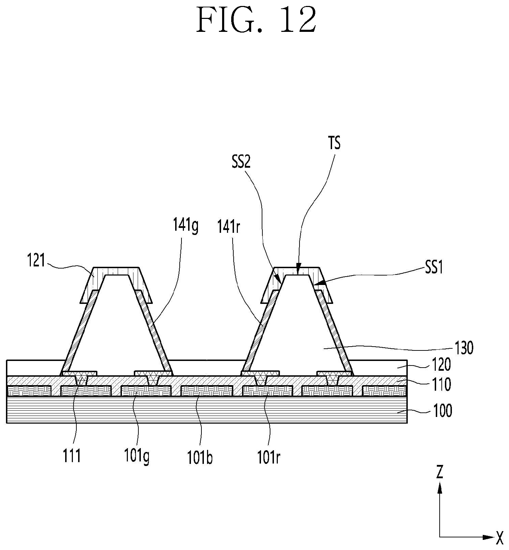

In order to solve the above-mentioned problems, as illustrated in FIG. 12, an additional bank 121 may be disposed on the upper surface TS of the three-dimensional structure 130.

After the first anode electrode 141r of the first organic light-emitting element 140r is formed on the first lateral surface SS1 of the three-dimensional structure 130 and the second anode electrode 141g of the second organic light-emitting element 140g is formed on the second lateral surface SS2 of the three-dimensional structure 130, an additional bank 121 may be formed.

One end of the first anode electrode 141r and one end of the second anode electrode 141g may be positioned lower than the upper surface TS of the three-dimensional structure 130. Accordingly, after the first anode electrode 141r and the second anode electrode 141g are formed, the upper surface TS of the three-dimensional structure 130, a part of the upper side of the first lateral surface SS1, and a part of the upper side of the second lateral surface SS2 may be exposed.

The additional bank 121 may be formed on the exposed regions, that is, the upper surface TS of the three-dimensional structure 130, a part of the upper side of the first lateral surface SS1, and a part of the upper side of the second lateral surface SS2. The additional bank 121 may be formed to vertically overlap with the upper region of the first anode electrode 141r on the first lateral surface SS1 of the three-dimensional structure 130, and may be formed to vertically overlap with the upper region of the second anode electrode 141g on the second lateral surface SS2 of the three-dimensional structure 130.

The three-dimensional structure 130 may not be exposed by the first anode electrode 141r, the second anode electrode 141g, and the additional bank 121.

Accordingly, as illustrated in FIGS. 10B and 11C, even if the first organic emission layer 142r of the first organic light-emitting element 140r and the second organic emission layer 142g of the second organic light-emitting element 140g are removed through a dry etching process, the additional bank 121 may serve as a stopper, so that the upper surface TS of the three-dimensional structure 130 may not be over-etched.

In addition, the organic component of the three-dimensional structure 130 may be physically separated from the first organic emission layer 142r of the first organic light-emitting element 140r or the second organic emission layer 142g of the second organic light-emitting element 140g by the additional bank 121, so that the shortening of the lifespan of the first organic light-emitting element 140r or the second organic light-emitting element 140g can be prevented.

In addition, since the upper end or corner of each of the first anode electrode 141r and the second anode electrode 141g is covered by the additional bank 121, current concentration at the upper end or corner of each of the first anode electrode 141r and the second anode electrode 141g may be blocked, so that an electrical short between the anode and the cathode may not occur even when driven for a long time.

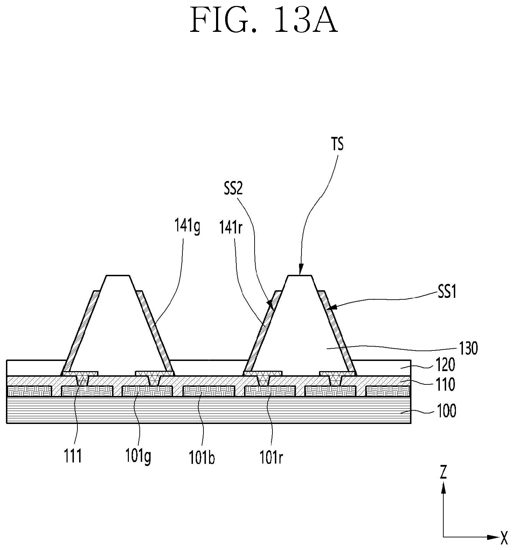

FIGS. 13A to 13D illustrate a manufacturing process of an additional bank disposed on an upper surface of a three-dimensional structure.

As illustrated in FIG. 13A, the first anode electrode 141r and the second anode electrode 141g may be formed on the first lateral surface SS1 and the second lateral surface SS2 of the three-dimensional structure 130, and a plurality of first banks 120 may be formed between the three-dimensional structure 130.

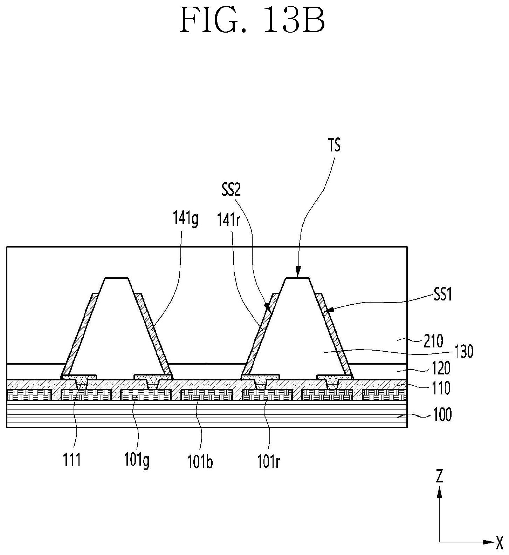

As illustrated in FIG. 13B, a photosensitive film 210 may be formed on the substrate 100, and after a soft baking process is performed, an exposure process may be performed.

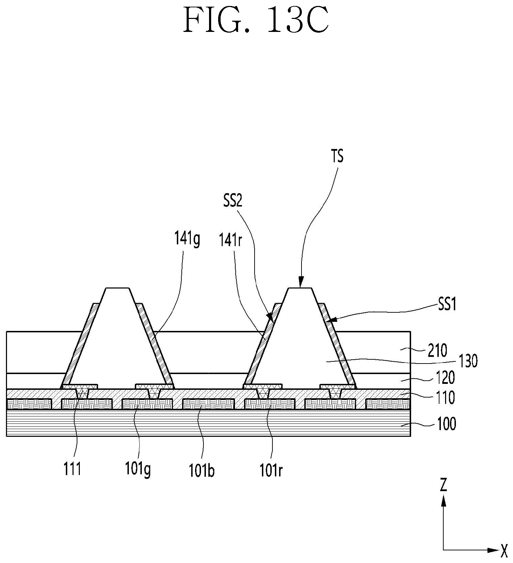

As illustrated in FIG. 13C, by performing a development process, an upper region of the photosensitive film 210 may be removed. As a result, the upper surface TS of the three-dimensional structure 130 may be exposed, and the upper surface TS of the photosensitive film 210 may be positioned lower than the upper end of the first anode electrode 141r and/or the upper end of the second anode electrode 141g.

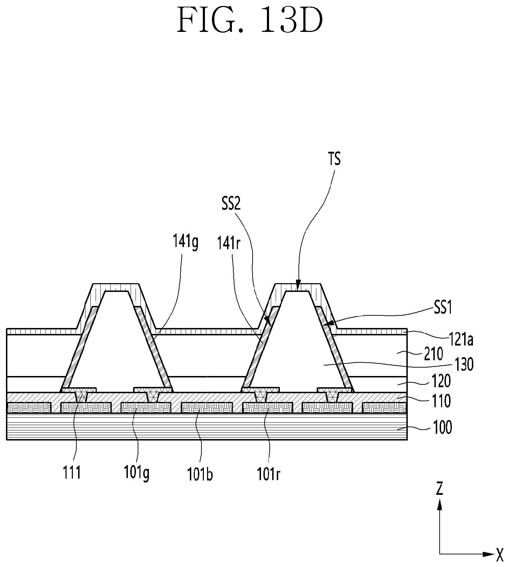

As illustrated in FIG. 13D, after an inorganic film 121a is formed on the substrate 100, a lift-off process may be performed. By performing the lift-off process, the photosensitive film 210 and the inorganic film 121a between the three-dimensional structure 130 may be removed. As a result, an additional bank 121 may be formed around the upper side of the three-dimensional structure 130. The additional bank 121 may be formed on the upper surface TS of the three-dimensional structure 130. The additional bank 121 may be formed on the upper region of the first lateral surface SS1 and the upper region of the second lateral surface SS2 of the three-dimensional structure 130.

### [Fourth Embodiment]

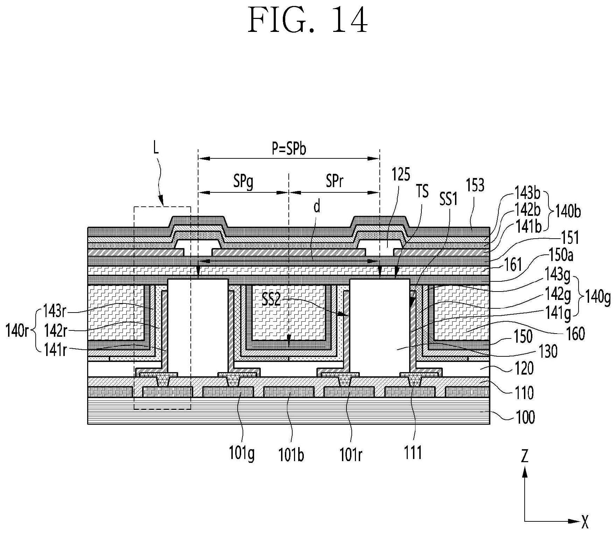

FIG. 14 is a cross-sectional view illustrating an organic light-emitting display device according to a fourth embodiment. FIG. 14 is a cross-sectional view taken along the line B-B' of the organic light-emitting display device of FIG. 8.

The fourth embodiment is the same as the third embodiment (FIG. 9) except that the first lateral surface SS1 and the second lateral surface SS2 of the three-dimensional structure 130 are each perpendicular to the substrate 100. In the fourth embodiment, components having the same structure, shape, and/or function as those of the third embodiment (FIG. 9) are given the same drawing reference numerals, and detailed descriptions thereof will be omitted.

Referring to FIGS. 8 and 14, the organic light-emitting display device according to the fourth embodiment may comprise a substrate 100, a plurality of driving circuits 101r, 101g, and 101b, a protective layer 110, a plurality of three-dimensional structures 130, a plurality of banks 120 and 125, a plurality of organic light-emitting elements 140r, 140g, and 140b, a plurality of insulating layers 150 to 153 and 160, etc.

The first lateral surface SS1 and the second lateral surface SS2 of the three-dimensional structure 130 may be each perpendicular to the substrate 100. For example, the first lateral surface SS1 and the second lateral surface SS2 of the three-dimensional structure 130 may each be at 90 degrees with respect to the substrate 100. In this instance, the first organic light-emitting element 140r may be disposed in the first subpixel SPr on the first lateral surface SS1 of the three-dimensional structure 130, and the second organic light-emitting element 140g may be disposed in the second subpixel SPg on the second lateral surface SS2 of the three-dimensional structure 130.

Since the first lateral surface SS1 and the second lateral surface SS2 of the three-dimensional structure 130 are each perpendicular to the substrate 100, the occupied area of the first organic light-emitting element 140r and the occupied area of the second organic light-emitting element 140g can be minimized when viewed from the front side, so that an ultra-high-resolution display can be implemented.

In contrast, since the first lateral surface SS1 and the second lateral surface SS2 of the three-dimensional structure 130 are secured as the emission regions of the first subpixel SPr and the second subpixel SPg, respectively, the first color light and the second color light may be sufficiently emitted toward the front side, so that the reduction in the lifetime luminous efficacy can be prevented.

The transverse current leakage prevention structure illustrated in FIGS. 10A to 10C may be applied to FIG. 14.

In this instance, a plurality of insulating layers 150, 150a, 151, 153, 160, and 161 may be disposed between the first organic light-emitting element 140r, the second organic light-emitting element 140g, and the third organic light-emitting element 140b. A first inorganic insulating layer 150 and a first organic insulating layer 160 may be disposed between the first organic light-emitting element 140r and the second organic light-emitting element 140g. The first inorganic insulating layer 150 and the first organic insulating layer 160 may surround lateral surfaces SS1 and SS2 of the three-dimensional structure 130.

An additional inorganic insulating layer 150a, a second organic insulating layer 161, and a second inorganic insulating layer 151 may be disposed on the three-dimensional structure 130 and the first organic insulating layer 160. A third inorganic insulating layer 153 may be disposed on the third cathode electrode 143b of the third organic light-emitting element 140b.

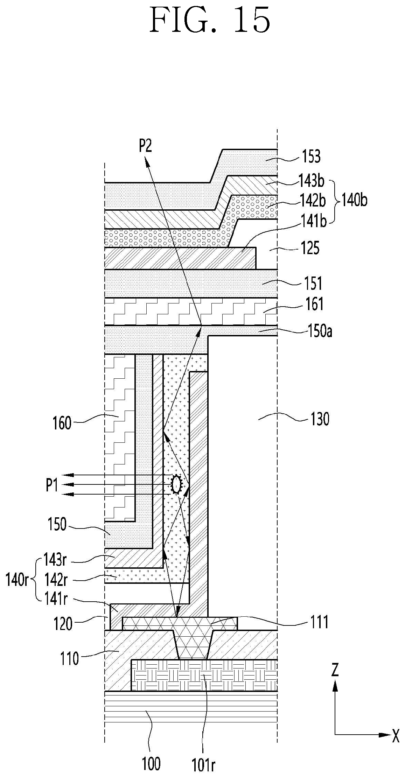

FIG. 15 illustrates a light propagation path in the L region of FIG. 14.

The first color light emitted from the first organic light-emitting element 140r and the second color light emitted from the second organic light-emitting element 140g may be transmitted to the organic insulating layer 160 between the three-dimensional structure 130.

For example, the first anode electrode 141r and the second anode electrode 141g may each comprise a reflective electrode. For example, the first cathode electrode 143r and the second cathode electrode 143g may each comprise a translucent conductive film. In this instance, the first color light or the second color light may be reflected by the reflective electrode and the conductive film and may be emitted toward the front side.

Here, P1 and P2 may represent light paths. For example, the first color light may be transmitted laterally to the first organic emission layer 142r within the first organic light-emitting element 140r (P1). For example, the first color light may be totally reflected upward within the first organic light-emitting element 140r and may be emitted toward the front side (P2).

That is, the first color light may be emitted while undergoing constructive interference in a current direction of the first organic light-emitting element 140r, and the light totally reflected within the first organic light-emitting element 140r may be emitted in a direction perpendicular to the current direction along the second path P2. In particular, according to the structure illustrated in FIG. 15, the first color light may be effectively emitted in an upward direction by being reflected by the auxiliary electrode 111 connected to the first anode electrode 141r.

The organic insulating layer 160 may comprise light-scattering particles. In this instance, light that has traveled along the first path P1 may be scattered by the light-scattering particles in the organic insulating layer 160 and emitted toward the front side. Since more light is extracted to the outside by the light-scattering particles, the light luminance can be increased.

The above detailed description should not be construed as limiting in all aspects but should be considered as illustrative. The scope of the embodiment should be determined by a reasonable interpretation of the appended claims, and all changes within the equivalent scope of the embodiment are included in the scope of the embodiment.

## Claims

1. An organic light-emitting display device, comprising:
a plurality of three-dimensional structures on a substrate; and
a plurality of pixels on the substrate,
wherein the plurality of pixels each comprise a first subpixel, a second subpixel, and a third subpixel having a three-dimensional structure,
wherein the first subpixel is disposed on a first lateral surface of the three-dimensional structure, and the second subpixel is disposed on a second lateral surface of the three-dimensional structure,
wherein the second subpixel is disposed to horizontally overlap the first subpixel, and the third subpixel is disposed on the first subpixel and the second subpixel, and
wherein the first subpixel comprises a first organic light-emitting element, the second subpixel comprises a second organic light-emitting element, and the third subpixel comprises a third organic light-emitting element.

2. The organic light-emitting display device of claim 1, wherein the third subpixel is disposed on an upper surface of the three-dimensional structure.

3. The organic light-emitting display device of claim 2, wherein the second organic light-emitting element is disposed to overlap horizontally with the first organic light-emitting element, and the third organic light-emitting element is disposed on the upper surface of the three-dimensional structure.

4. The organic light-emitting display device of claim 3, wherein the first organic light-emitting element, the second organic light-emitting element, and the third organic light-emitting element each comprise an anode electrode, a low-resistance layer, an organic emission layer, and a cathode electrode, and
wherein the anode electrode is independently disposed in the first subpixel, the second subpixel, and the third subpixel.

5. The organic light-emitting display device of claim 4, wherein a low-resistance layer of the first organic light-emitting element and a low-resistance layer of the second organic light-emitting element are disposed to be spaced apart from each other between the plurality of three-dimensional structures, and
wherein a first organic emission layer of the first organic light-emitting element and a second organic emission layer of the second organic light-emitting element are disposed to overlap horizontally between the plurality of three-dimensional structures.

6. The organic light-emitting display device of claim 4, wherein a low-resistance layer, an organic emission layer, and a cathode electrode of the first organic light-emitting element and a low-resistance layer, an organic emission layer, and a cathode electrode of the second organic light-emitting element are spaced apart from each other on the upper surface of the three-dimensional structure.

7. The organic light-emitting display device of claim 4, wherein a first anode electrode of the first organic light-emitting element and a second anode electrode of the second organic light-emitting element each comprise a reflective metal, and a first cathode electrode of the first organic light-emitting element and a second cathode electrode of the second organic light-emitting element each comprise a transparent or translucent conductive film.

8. The organic light-emitting display device of claim 1, wherein the third subpixel is disposed on the first subpixel and the second subpixel between the plurality of three-dimensional structures.

9. The organic light-emitting display device of claim 8, wherein a size of the pixel is a same as a size of the third subpixel.

10. The organic light-emitting display device of claim 8, wherein a size of the pixel is equal to a sum of a size of the first subpixel and a size of the second subpixel.

11. The organic light-emitting display device of claim 8, wherein the second organic light-emitting element is disposed to horizontally overlap the first organic light-emitting element, and the third organic light-emitting element is disposed to vertically overlap the first organic light-emitting element and the second organic light-emitting element.

12. The organic light-emitting display device of claim 8, wherein the first organic light-emitting element, the second organic light-emitting element, and the third organic light-emitting element each comprise an anode electrode, an organic emission layer, and a cathode electrode, and
wherein the anode electrode is independently disposed in the first subpixel, the second subpixel, and the third subpixel, and the cathode electrode is commonly disposed in the first subpixel and the second subpixel.

13. The organic light-emitting display device of claim 12, wherein the first subpixel, the second subpixel, and the third subpixel each comprise an emission region and a non-emission region, and the emission region has a size corresponding to the anode electrode.

14. The organic light-emitting display device of claim 13, wherein a size of a third anode electrode of the third organic light-emitting element is greater than a size of a first anode electrode of the first organic light-emitting element or a size of a second anode electrode of the second organic light-emitting element.

15. The organic light-emitting display device of claim 13, wherein a third anode electrode of the third organic light-emitting element is configured to vertically overlap a first anode electrode of the first organic light-emitting element and a second anode electrode of the second organic light-emitting element.

16. The organic light-emitting display device of claim 12, wherein an end of an organic emission layer of the first organic light-emitting element and an end of an organic emission layer of the second organic light-emitting element are positioned lower than an upper surface of the three-dimensional structure.

17. The organic light-emitting display device of claim 1, comprising:
a plurality of first banks between the plurality of three-dimensional structures; and
a plurality of second banks between the plurality of third subpixels.

18. The organic light-emitting display device of claim 17, wherein a distance between the plurality of second banks is a same as a width of the pixel or a width of the third subpixel.

19. The organic light-emitting display device of claim 1, comprising:
a plurality of insulating layers between the first organic light-emitting element, the second organic light-emitting element, and the third organic light-emitting element,
wherein the plurality of insulating layers comprise at least one organic insulating layer and at least one inorganic insulating layer.

20. The organic light-emitting display device of claim 1, wherein the first lateral surface and the second lateral surface of the three-dimensional structure are each inclined or perpendicular to a ground.
